(19) Europäisches Patentamt / European Patent Office / Office européen des brevets

(11) **EP 3 051 303 B1**

(12) **EUROPÄISCHE PATENTSCHRIFT**

(45) Veröffentlichungstag und Bekanntmachung des Hinweises auf die Patenterteilung:
**20.11.2019 Patentblatt 2019/47**

(51) Int Cl.:
*H04B 5/00* (2006.01)  *H04B 17/21* (2015.01)
*G01R 29/08* (2006.01)  *G01R 29/10* (2006.01)

(21) Anmeldenummer: **16151816.2**

(22) Anmeldetag: **19.01.2016**

(54) **NAHFELDMESSUNG VON AKTIVEN ANTENNENSYSTEMEN**

NEAR-FIELD MEASUREMENT OF ACTIVE ANTENNA SYSTEMS

MESURE DE PROXIMITE DE SYSTEMES D'ANTENNES ACTIVES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.01.2015 DE 102015001002**

(43) Veröffentlichungstag der Anmeldung:
**03.08.2016 Patentblatt 2016/31**

(73) Patentinhaber: **KATHREIN SE**
**83022 Rosenheim (DE)**

(72) Erfinder:
• **STEINHAUSER, Karl-August, Dr. rer. nat.**
  **81545 München (DE)**
• **FRITZE, Stefan**
  **83026 Rosenheim (DE)**

(74) Vertreter: **Flach Bauer Stahl**
**Patentanwälte Partnerschaft mbB**
**Adlzreiterstraße 11**
**83022 Rosenheim (DE)**

(56) Entgegenhaltungen:
EP-A1- 2 811 307  US-A- 5 809 087
US-A1- 2003 117 315

**Beschreibung**

Die Erfindung betrifft ein Verfahren und eine Messvorrichtung zur Bestimmung von Betrag und Phase eines durch eine zu untersuchende aktive Antenne empfangenen Signals anhand von gemessenen Leistungswerten. Anhand des erfassten Betrags und der Phase ist es dann möglich das Antennenfernfelddiagramm zu ermitteln.

Hierzu stehen verschiedene Verfahren zur Verfügung. Das Antennenfernfelddiagramm kann beispielsweise über eine Fernfeldmessung direkt ermittelt werden. Eine solche Fernfeldmessung ist in der Praxis allerdings wenig praktikabel, da diese durch viele andere Geräte gestört werden würde. Eine weitere Möglichkeit besteht in der Nutzung einer Kompakt-Messkammer (engl. compact range chamber), eine ebene Welle kann zur Messung mittels eines Feedhorns und eines Spiegels erzeugt werden. Allerdings ist ein solcher Aufbau von den Abmessungen her sehr groß und die Messkammer insgesamt sehr teuer, so dass auch ein solches Verfahren in der Praxis wenig praktikabel ist.

Daher wird überwiegend eine Nahfeldmessung durchgeführt, weil sie mit relativ geringen Kammergrößen auskommt. Wenn geschirmte Messkammern verwendet werden, dann können die Messungen völlig unabhängig von externen HF-Diensten und Störern durchgeführt werden. Bei einer solchen Nahfeldmessung wird in der Messkammer die zu untersuchende Antenne im Nahfeld gemessen. Wenn sowohl der Betrag als auch die Phase über den gesamten Raumwinkel oder über ausgewählte Bereiche erfasst ist, lässt sich daraus das gesuchte Antennenfernfelddiagramm mathematisch ermitteln. Dies geschieht mittels einer Nahfeld-Fernfeld-Transformation.

Problematisch ist eine solche Nahfeldmessung allerdings bei aktiven Antennensystemen (AAS) bei denen die HF-Verbindung zwischen Antenne und Radio gewöhnlich nicht zugänglich ist. Hier müssen die erforderlichen Daten an der üblicherweise digitalen Schnittstelle entnommen bzw. eingespeist werden. An dieser Schnittstelle ist normalerweise nur die Leistung des Sende- bzw. Empfangssignals verfügbar. Die Phaseninformation kann dagegen nicht oder nur sehr schwierig extrahiert werden. Hierzu ist meistens eine Zusammenarbeit mit dem Hersteller des aktiven Antennensystems notwendig. Ohne eine Phaseninformation ist allerdings die Nahfeld-Fernfeld-Transformation nicht durchführbar.

Bei einem aktiven Antennensystem wird allerdings die Kombination aus Antenne und Radioelektronik gemessen. Dabei müssen die Senderichtung und die Empfangsrichtung separat gemessen werden, weil sie unterschiedliche elektronische Bauteile betreffen.

Innerhalb des Standardisierungsgremiums von 3GPP wurde dieses Problem bereits unter R4-145044, "Near Field Measurement Setups for AAS BS OTA testing: 3GPP TSG-RAN4-Meating #72" diskutiert. Dort wurde ein Verfahren vorgeschlagen, bei dem eine Referenzantenne zusammen mit dem zu untersuchenden aktiven Antennensystem durch eine Drehanordnung bewegt wird, wodurch unterschiedliche Raumwinkel in Relation zu einer Sendeantenne einstellbar sind. Wenn das aktive Antennensystem als Sender fungiert kann durch direkten Vergleich der Phasen der HF-Signale von der Referenzantenne und der in diesem Fall als Empfänger agierenden Sendeantenne die benötigte Phaseninformation ermittelt werden.

Ungelöst ist allerdings das Problem, wie in Empfangsrichtung vorgegangen werden soll, also wenn das aktive Antennensystem als Empfänger fungiert. Außerdem ist weiterhin problematisch wie während der gesamten Dauer der Messung über alle Raumwinkel sichergestellt werden soll, dass die Phase nicht wegläuft, was wegen Temperaturdriften der Elektronik des aktiven Antennensystems nicht gewährleistet ist. Zusätzlich wäre noch eine Synchronisation zwischen dem separaten Sender und dem Empfänger des aktiven Antennensystems notwendig.

Aus der EP 2 811 307 A1 ist ein Sicherheitssystem für Flughäfen bekannt, welches dazu dient, verbotene Gegenstände unter der Kleidung einer Person zu detektieren. Eine erste Sendeantenne sendet ein Sendesignal in Richtung dieser Person, wohingegen eine zweite Sendeantenne ein Sendesignal Richtung eines Empfangs-Antennenarrays sendet. Das Sendesignal wird an der Person zumindest teilweise in Richtung des Empfangs-Antennenarrays reflektiert. Die Sendefrequenzen liegen dabei im Terra Hertz Bereich. Die einzelnen Antennenelemente des Empfangs-Antennenarrays sind mit Dioden verbunden und anschließend über Schalter an einen A/D-Wandler angeschlossen. Anhand von zumindest vier gemessenen Leistungswerten kann die Phase ermittelt werden, um daraus Rückschlüsse auf die Art und die Geometrie des verborgenen Gegenstands anstellen zu können.

Aus der US 2003 / 0117315 A1 ist ein Kalibriersystem bekannt, um ein Antennensystem mittels einer Near Field Probe zu kalibrieren.

Es ist daher die Aufgabe der Erfindung ein Verfahren und eine Messeinrichtung zu schaffen, mit denen es möglich ist den Betrag und die Phase eines aktiven Antennensystems zu ermitteln, wobei das aktive Antennensystem als Empfänger fungiert.

Die Aufgabe wird bezüglich des Verfahrens zur Bestimmung von Leistungswerten eines durch die aktive Antenne empfangenen Signals um damit den Betrag und die Phase bestimmen zu können durch die Merkmale des Anspruchs 1 gelöst. Weiterhin wird die Aufgabe bezüglich der Messeinrichtung zur Bestimmung von Leistungswerten eines durch eine aktive Antenne empfangenen Signals zur Berechnung von Betrag und Phase durch die Merkmale des Anspruchs 13 gelöst. In den jeweiligen Unteransprüchen sind vorteilhafte Weiterbildungen des erfindungsgemäßen Verfahrens, sowie der erfindungsgemäßen Messeinrichtung angegeben. Das erfindungsgemäße Verfahren zur Bestimmung von Leistungswerten eines durch die aktive Antenne empfangenen Signals um damit den Betrag und die Phase bestimmen zu können sieht vor, dass neben zumindest einer Sendeantenne auch eine Referenzantenne verwendet wird, wobei diese in vorgegebenem Abstand zur aktiven Antenne angeordnet ist und dass zusätzlich ein Signalgenerator verwendet wird, der mit der zumindest einen Sendeantenne und der Referenzantenne verbunden ist und ein Sendesignal erzeugt. Innerhalb des Verfahrens wird aus der Gruppe der nachfolgenden Verfahrensschritte:

ST1: Alleiniges Aussenden des Sendesignals durch die zumindest eine Sendeantenne und Erfassen eines Leistungswerts des durch die aktive Antenne empfangenen Sendesignals;

ST2: Alleiniges Aussenden des Sendesignals durch die Referenzantenne und Erfassen eines Leistungswerts des durch die aktive Antenne empfangenen Sendesignals;

ST3: Gleichzeitiges Aussenden des Sendesignals über die zumindest eine Sendeantenne und die Referenzantenne unter Erzeugung von überlagerten Sendesignalen und Erfassen eines Leistungswerts der durch die aktive Antenne empfangenen überlagerten Sendesignale;

eine Abfolge von zumindest drei Verfahrensschritten ST1, ST2, ST3 in beliebiger Reihenfolge und mit beliebiger Kombination, auch unter mehrfacher Durchführung zumindest eines Verfahrensschritts ST1, ST2, ST3 durchgeführt wird, wobei die Abfolge der zumindest drei Verfahrensschritte ST1, ST2, ST3 stets zumindest einmal den Verfahrensschritt ST3 umfasst. Dadurch, dass zumindest einmal der Verfahrensschritt ST3 ausgeführt wird, kann anhand der zumindest drei gemessenen Leistungswerte die Phase ermittelt werden. Der gesuchte Betrag kann direkt bei Ausführung von ST1 ermittelt werden oder anhand der drei gemessenen Leistungswerte, wenn ST1 nicht ausgeführt wird.

Auch die erfindungsgemäße Messeinrichtung zur Bestimmung von Leistungswerten eines durch eine aktive Antenne empfangenen Signals zur Berechnung von Betrag und Phase umfasst die bereits genannten Merkmale. Eine solche Messeinrichtung umfasst neben zumindest einer Sendeantenne auch eine Referenzantenne, wobei die Referenzantenne, wie bereits erläutert, mit festem, unveränderlichem Abstand und Richtung zur aktiven Antenne angeordnet ist. Die Messeinrichtung umfasst außerdem einen Signalgenerator der das Sendesignal erzeugen kann. Der Signalgenerator ist dabei bevorzugt sowohl mit der zumindest einen Sendeantenne als auch mit der Referenzantenne verbunden. Weiterhin weist die Messeinrichtung eine Steuereinheit auf, die derart ausgebildet ist, dass sie die nachfolgenden Verfahrensschritte ausführen kann:

ST1: Alleiniges Aussenden des Sendesignals durch die zumindest eine Sendeantenne und Erfassen eines Leistungswerts des durch die aktive Antenne empfangenen Sendesignals;

ST2: Alleiniges Aussenden des Sendesignals durch die Referenzantenne und Erfassen eines Leistungswerts des durch die aktive Antenne empfangenen Sendesignals;

ST3: Gleichzeitiges Aussenden des Sendesignals über die zumindest eine Sendeantenne und die Referenzantenne unter Erzeugung von überlagerten Sendesignalen und Erfassen eines Leistungswerts der durch die aktive Antenne empfangenen überlagerten Sendesignale.

Die Steuereinheit ist weiterhin dazu ausgebildet, dass eine Abfolge von zumindest drei Verfahrensschritten ST1, ST2, ST3 in beliebiger Reihenfolge und mit beliebiger Kombination, auch unter mehrfacher Durchführung zumindest eines Verfahrensschritts ST1, ST2, ST3 durchgeführt wird, wobei die Abfolge der zumindest drei Verfahrensschritte ST1, ST2, ST3 stets zumindest einmal den Verfahrensschritt ST3 umfasst.

Weiterhin konkretisieren das erfindungsgemäße Verfahren und die erfindungsgemäße Messeinrichtung die Abfolgen derart, dass für jede der exemplarisch beschriebenen Abfolgen a), b), c) die entsprechenden nachfolgenden Verfahrensschritte in beliebiger Reihenfolge ausgeführt werden. Innerhalb der Abfolge a) wird der Verfahrensschritt ST1 oder ST2 durchgeführt. Es wird auch der Verfahrensschritt ST3 ausgeführt, welcher so oft wiederholt wird, bis zumindest drei Leistungswerte erfasst sind. Innerhalb der Abfolge b) werden die Verfahrensschritte ST1, ST2 und ST3 durchgeführt. In der Abfolge c) wird der Verfahrensschritt ST3 derart oft durchgeführt, bis zumindest drei Leistungswerte erfasst sind. Diese Abfolgen a), b), c) erlauben mit ihren jeweiligen Verfahrensschritten die Berechnung von Leistungswerten, mit denen auf sehr einfache Art und Weise der gesuchte Betrag und die gesuchte Phase ermittelt werden können.

Das erfindungsgemäße Verfahren und die erfindungsgemäße Messeinrichtung beschreiben die Abfolgen a), b) und c) im Weiteren noch detaillierter. In der Abfolge a) wird außerdem vorteilhaft noch ein Phasensteller und/oder Amplitudensteller verwendet, bzw. die Messeinrichtung weist vorteilhaft noch einen solchen Phasensteller und/ oder Amplitudensteller auf. Nachdem der Verfahrensschritt ST3 durchgeführt wurde, wird eine Phasenveränderung zwischen dem Sendesignal an der zumindest einen Sendeantenne und dem Sendesignal an der Referenzantenne und/oder eine Amplitudenveränderung des Sendesignals an der zumindest einen Sendeantenne und/oder des Sendesignals an der Referenzantenne durchgeführt. Danach werden die Verfahrensschritte ST3 und Phasenveränderung und/ oder Amplitudenveränderung solange erneut ausgeführt, bis für zumindest zwei unterschiedliche Phasenwerte zwischen dem Sendesignal an der zumindest einen Sendeantenne und dem Sendesignal an der Referenzantenne und/oder für zumindest zwei unterschiedliche Amplitudenwerte des Sendesignals an der zumindest einen Sendeantenne und/ oder des Sendesignals an der Referenzantenne zumindest je ein Leistungswert erfasst ist. Mit dem erfassten Leistungswert aus dem Verfahrensschritt ST1 oder ST2 liegen damit drei Leistungswerte vor. Mittels der zumindest drei Leistungswerte kann die Phasendifferenz an der aktiven Antenne zwischen dem Sendesignal, das von der zumindest einen Sendeantenne ausgesendet wurde und dem Sendesignal, das von der Referenzantenne ausgesendet wurde, berechnet werden. Der Betrag des Sendesignals, das von der zumindest einen Sendeantenne ausgesendet und von der aktiven Antenne empfangen wurde kann auch leicht ermittelt werden. Entweder wird dieser direkt dem gemessenen Leistungswert aus dem Verfahrensschritt ST1 entnommen, wenn dieser durchgeführt wurde, oder aber er wird aus den zumindest drei Leistungswerten berechnet, von denen zumindest zwei aus dem überlagerten Sendesignal ermittelt wurden.

Innerhalb der Abfolge b) wird einzig noch verdeutlichst, dass die Phase aus den zumindest drei Leistungswerten errechnet wird und dass der Betrag aus der gemessenen Leistung im Verfahrensschritt ST1 ermittelt wird.

In der Abfolge c) wird ebenfalls vorteilhaft noch ein Phasensteller und/oder Amplitudensteller verwendet, bzw. die Messeinrichtung weist vorteilhaft einen solchen Phasensteller und/oder Amplitudensteller auf. Nachdem der Verfahrensschritt ST3 durchgeführt wurde, wird eine Phasenveränderung zwischen dem Sendesignal an der zumindest einen Sendeantenne und dem Sendesignal an der Referenzantenne und/oder eine Amplitudenveränderung des Sendesignals an der zumindest einen Sendeantenne und/oder des Sendesignals an der Referenzantenne durchgeführt. Danach werden die Verfahrensschritte ST3 und Phasenveränderung und/oder Amplitudenveränderung solange erneut ausgeführt, bis für zumindest drei unterschiedliche Phasenwerte zwischen dem Sendesignal an der zumindest einen Sendeantenne und dem Sendesignal an der Referenzantenne und/oder bis für zumindest drei unterschiedliche Amplitudenwerte des Sendesignals an der zumindest einen Sendeantenne und/oder des Sendesignals an der Referenzantenne zumindest je ein Leistungswert erfasst ist. Anhand der zumindest drei Leistungswerte werden die gesuchte Phase und der gesuchte Betrag ermittelt.

Ein erfindungsgemäßer Vorteil liegt außerdem dann vor, wenn in dem Verfahren und in der Messeinrichtung die Leistungserfassung und Phasenveränderung und/oder Amplitudenveränderung derart oft nacheinander ausgeführt wird, bis für zumindest drei oder zumindest vier unterschiedliche Phasenwerte zwischen dem Sendesignal an der zumindest einen Sendeantenne und dem Sendesignal an der Referenzantenne und/oder bis für zumindest drei oder zumindest vier unterschiedliche Amplitudenwerte des Sendesignals an der zumindest einen Sendeantenne und/oder des Sendesignals an der Referenzantenne zumindest je ein Leistungswert erfasst ist. Dies erlaubt eine sichere Ermittlung der Phase auch für die Fälle, dass die Amplitude der beiden Sendesignale eine deutliche unterschiedliche Höhe aufweist.

Besonders vorteilhaft ist außerdem, wenn das Verfahren und die Messeinrichtung in der Lage sind eine Einheit, welche aus der aktiven Antenne und der Referenzantenne gebildet ist, gemeinsam gegenüber der zumindest einen Sendeantenne zu verdrehen und/oder zu verstellen. In diesem Fall können unterschiedliche Empfangsrichtungen, also unterschiedliche Raumwinkel gemessen werden. Wichtig dabei ist, dass sich die Referenzantenne und die aktive Antenne nicht gegeneinander verdrehen und/oder verstellen. Im Weiteren können das Verfahren und die Messeinrichtung die vorherigen Verfahrensschritte wiederholen, so dass für einen anderen Raumwinkel der Betrag und die Phase ermittelt werden. Besonders vorteilhaft dabei ist, wenn sowohl der Azimutwinkel, als auch der Elevationswinkel der Einheit, die aus der aktiven Antenne und der Referenzantenne gebildet ist, gegenüber der zumindest einen Sendeantenne verdreht und/ oder verstellt wird. In diesem Fall können alle Raumwinkel der aktiven Antenne vermessen werden. Die aktive Antenne kann daher in zwei Drehachsen verschwenkt werden.

Das Verfahren und die Messeinrichtung sind dann in der Lage die aktive Antenne zusammen mit der Referenzantenne derart zu verdrehen, bis für alle Raumwinkel der Betrag und die Phase ermittelt worden sind oder bis einzig für die gewünschten Raumwinkel der Betrag und die Phase ermittelt worden sind.

Sowohl bei der Messeinrichtung, als auch bei dem Verfahren ist es besonders vorteilhaft, wenn nacheinander vier Phasenveränderungen zwischen dem Sendesignal der zumindest einen Sendeantenne und dem Sendesignal an der Referenzantenne von 0°, $\Delta°$, $2 \cdot \Delta°$ und $3 \cdot \Delta°$ aufgeschalten werden, wobei $\Delta°$ im Bereich zwischen 80° und 100° liegt, bevorzugt 90° entspricht. Ein Aufschalten von einer weiteren Phasendifferenz von jeweils 90° kann besonders einfach mittels Hybriden, Invertern oder Umschaltern erreicht werden. Es ist dabei zu beachten, dass je nachdem, wie lange die verwendeten Kabel von dem HF-Generator zu der zumindest einen Sendeantenne und zu der Referenzantenne sind, bereits von Anfang an eine Phasenverschiebung zwischen beiden Sendesignalen vorliegt. Der Phasensteller stellt daher nicht eine Phasenverschiebung von beispielsweise exakt 90° zwischen dem Sendesignal der zumindest einen Sendeantenne und dem Sendesignal der Referenzantenne am Ort der aktiven Antenne ein, sondern erhöht nur einen möglicherweise bestehenden Phasenversatz um weitere 90°.

Außerdem besteht ein Vorteil, wenn innerhalb des Verfahrens und innerhalb der Messeinrichtung ein Amplitudensteller verwendet wird, der zwischen dem Signalgenerator und der zumindest einen Sendeantenne und/oder zwischen dem Signalgenerator und der Referenzantenne geschalten ist. Mittels des Amplitudenstellers ist es möglich die Amplitude des Sendesignals an der zumindest einen Sendeantenne und/oder die Amplitude des Sendesignals an der Referenzantenne derart einzustellen, dass die Leistung des Sendesignals der zumindest einen Sendeantenne an der aktiven Antenne in etwa der Leistung des Sendesignals der Referenzantenne an der aktiven Antenne entspricht. Bevorzugt sind die Leistungen beider Sendesignale an der aktiven Antenne daher gleich hoch. Es ist allerdings ausreichend, wenn eine Leistung eines Sendesignals weniger als 20-mal so hoch ist, bevorzugt weniger als zehnmal so hoch ist, oder weiter bevorzugt weniger als fünfmal so hoch ist, oder weiter bevorzugt weniger als zweimal so hoch ist, als die Leistung des anderen Sendesignals. In diesem Fall kann die Phase für einen Raumwinkel besonders genau berechnet werden.

Weiterhin ist es bei dem erfindungsgemäßen Verfahren und bei der erfindungsgemäßen Messeinrichtung vorteilhaft, wenn die zumindest eine Sendeantenne und/oder die Referenzantenne ein moduliertes oder unmoduliertes Sendesignal aussenden. Dies erlaubt, dass auch aktive Antennen vermessen werden können, die nur mit modulierten Signalen arbeiten.

Schlussendlich ist es bei dem erfindungsgemäßen Verfahren und bei der erfindungsgemäßen Messeinrichtung vorteilhaft, wenn die Referenzantenne besonders nahe an der aktiven Antenne angeordnet ist, der Abstand insbesondere weniger als 100 cm, bevorzugt weniger als 50 cm, weiter bevorzugt weniger als 25 cm und weiter bevorzugt weniger als 10 cm beträgt.

Verschiedene Ausführungsbeispiele der Erfindung werden nachfolgend unter Bezugnahme auf die Zeichnungen beispielhaft beschrieben. Gleiche Gegenstände weisen dieselben Bezugszeichen auf. Die entsprechenden Figuren der Zeichnung zeigen im Einzelnen:

Figur 1: eine vereinfachte Darstellung der Messeinrichtung, die die Anordnung der Referenzantenne an der aktiven Antenne verdeutlicht;

Figur 2A: eine vereinfachte Darstellung der Messeinrichtung, die das Zusammenwirken verschiedener Komponenten, wie beispielsweise den Signalgenerator, die zumindest eine Sendeantenne, den Phasensteller und die Steuereinheit zusammen mit der aktiven Antenne und der Referenzantenne verdeutlicht;

Figur 2B: eine weitere vereinfachte Darstellung der Messeinrichtung, die das Zusammenwirken verschiedener Komponenten, wie beispielsweise den Signalgenerator, die zumindest eine Sendeantenne, den Phasensteller und die Steuereinheit zusammen mit der aktiven Antenne und der Referenzantenne und einem Schnittstellengerät verdeutlicht;

Figur 3: eine Darstellung, die die durch die aktive Antenne empfangenen überlagerten Sendesignale verdeutlicht, wobei die überlagerten Sendesignale einmal die gleiche Amplitude haben und einmal nicht;

Figur 4: eine Darstellung die verschiedene nachgebildete überlagerte Sendesignale zeigt und verdeutlicht, wie die Phasendifferenz für jedes nachgebildete Sendesignal ermittelt wird;

Figur 5: mehrere Ablaufdiagramme, welche die Verfahrensschritte ST1, ST2 und ST3 näher erläutern;

Figur 6A: ein Ablaufdiagramm zur Bestimmung der Leistungswerte eines durch die aktive Antenne empfangenen Signals gemäß der Abfolge a);

Figur 6B: ein weiteres Ablaufdiagramm zur Bestimmung der Leistungswerte eines durch die aktive Antenne empfangenen Signals gemäß der Abfolge b);

Figur 6C: ein weiteres Ablaufdiagramm zur Bestimmung der Leistungswerte eines durch die aktive Antenne empfangenen Signals gemäß der Abfolge c);

Figur 7A: ein weiteres Ablaufdiagramm zur Bestimmung der Leistungswerte und des Betrags und der Phase eines durch die aktive Antenne empfangenen Signals gemäß der Abfolge a);

Figur 7B: ein weiteres Ablaufdiagramm zur Bestimmung der Leistungswerte und des Betrags und der Phase eines durch die aktive Antenne empfangenen Signals gemäß der Abfolge b);

Figur 7C: ein weiteres Ablaufdiagramm zur Bestimmung der Leistungswerte und des Betrags und der Phase eines durch die aktive Antenne empfangenen Signals gemäß der Abfolge c);

Figur 8: ein weiteres Ablaufdiagramm, welches Veränderung des Azimutwinkels und des Elevationswinkels erläutert, um den Betrag und die Phase eines durch die aktive Antenne empfangenen Signals für unterschiedliche Raumwinkel zu erfassen;

Figur 9:    ein weiteres Ablaufdiagramm, welches erläutert, wie die Beträge und Phasen für alle Raumwinkel ermittelt werden, um das Antennenfernfelddiagramm bestimmen zu können; und

Figur 10:    ein weiteres Ablaufdiagramm, welches die Anpassung der Amplitude des Sendesignals der zumindest einen Sendeantenne an die Amplitude des Sendesignals der Referenzantenne beschreibt.

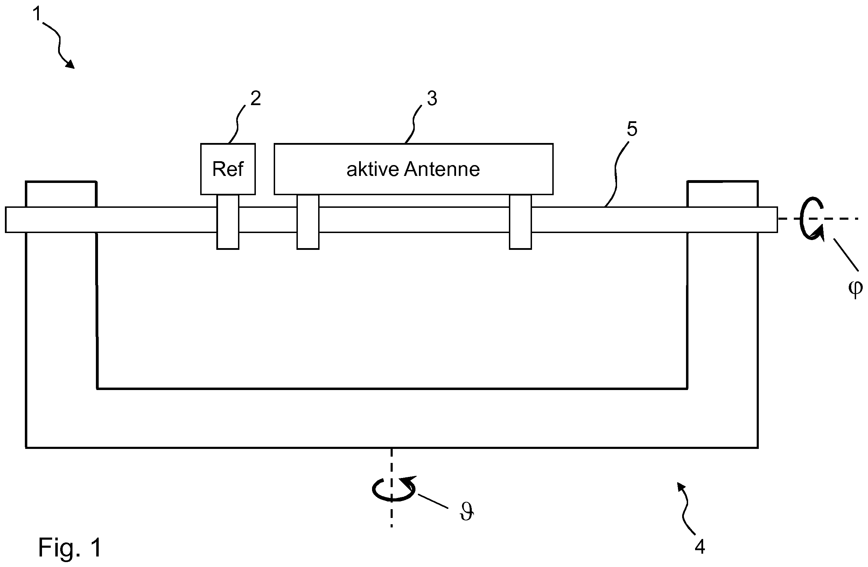

Figur 1 zeigt eine vereinfachte Darstellung der Messeinrichtung 1, die eine Anordnung der Referenzantenne 2 an der aktiven Antenne 3 verdeutlicht. Sowohl die Referenzantenne 2, als auch die aktive Antenne 3 sind an einer Dreheinheit 4 angeordnet. Die Dreheinheit 4 erlaubt, dass die Referenzantenne 2 und die aktive Antenne 3 gemeinsam verdreht und/oder verstellt werden können. Das Verdrehen und/oder Verstellen ist dabei mit zwei Drehachsen $\vartheta$, $\varphi$ möglich. Dies erlaubt, dass die aktive Antenne 3 und die Referenzantenne 2, die bezüglich ihrer möglichen Bewegung als eine gemeinsame Einheit dargestellt werden, bezüglich ihres Azimutwinkels $\varphi$ und/oder ihres Elevationswinkels $\vartheta$ gegenüber einer in Figur 1 nicht dargestellten Sendeantenne 6 verdreht und/oder verstellt werden können.

Die Referenzantenne 2 und die aktive Antenne 3 sind an einer Antennenhalterung 5 befestigt. Diese Antennenhalterung 5 ist mit der Dreheinheit 4 entsprechend mechanisch verbunden, bzw. in diese eingespannt. Bevorzugt ist die Referenzantenne 2 möglichst nahe an der aktiven Antenne 3 angeordnet. Der Abstand zwischen der Referenzantenne 2 und der aktiven Antenne 3 beträgt weniger als 100 cm, bevorzugt weniger als 50 cm, weiter bevorzugt weniger als 25 cm und weiter bevorzugt weniger als 10 cm. Die Hauptabstrahlrichtung der Referenzantenne 2 sollte in Richtung der aktiven Antenne 3 zeigen.

Die Referenzantenne 2 und die aktive Antenne 3 sind stets gleich, also starr zueinander hin ausgerichtet. Dies bedeutet, dass es mit der Dreheinheit 4 nicht möglich ist, die Referenzantenne 2 gegenüber der aktiven Antenne 3 oder umgekehrt zu verdrehen. Die Dreheinheit 4 erlaubt einzig, dass eine aus der Referenzantenne 2 und der aktiven Antenne 3 gebildete Einheit gegenüber der Umgebung, zu der auch die Sendeantenne 6 gehört, verdreht und/oder verstellt werden kann.

Die Dreheinheit 4 beinhaltet beispielsweise einen Schrittmotor. Dadurch, dass sowohl der Azimutwinkel $\varphi$ als auch der Elevationswinkel $\vartheta$ der Einheit bestehend aus Referenzantenne 2 und aktiver Antenne 3 verändert werden können, können für sämtliche Raumwinkel $\vartheta$, $\varphi$ der aktiven Antenne 3 der Betrag und die Phase gemessen werden.

Bei einer aktiven Antenne handelt es sich um eine Antenne, bei der die HF-Verbindung zwischen der eigentlichen Antenne und dem Radio nicht zugänglich sein muss. Die empfangenen Daten müssen an der üblicherweise digitalen Schnittstelle entnommen, bzw. eingespeist werden. Bei einem solchen aktiven Antennensystem 3 steht an dieser Schnittstelle meist nur die Leistung des Sende- bzw. Empfangssignals zur Verfügung. Die Phaseninformation kann dagegen nicht oder nur sehr schwierig, also unter Mithilfe des Herstellers der aktiven Antenne 3 extrahiert werden. Wie bereits erläutert ist allerdings ohne die Phaseninformation eine Nahfeld-Fernfeld-Transformation nicht möglich. Die Reziprozität der aktiven Antenne 3 ist gerade nicht gegeben, weil innerhalb des Sende- und Empfangspfades unterschiedliche Filter und Elektronikbauteile verwendet werden. Daher muss, wie bereits erläutert, neben der Senderichtung auch die Empfangsrichtung separat gemessen werden.

Die Referenzantenne 2 und die aktive Antenne 3 sind mechanisch über die Antennenhalterung 5 miteinander gekoppelt. Der Abstand zwischen der Referenzantenne 2 und der aktiven Antenne 3 kann durch Lösen einer Feststellverbindung, wie beispielsweise einer Klemmverbindung an der Referenzantenne 2 und/oder an der aktiven Antenne 3, verändert werden. Die Referenzantenne 2 und/oder die aktive Antenne 3 können bei gelöster Feststellverbindung auf der Antennenhalterung 5 hin und her verschoben werden. Während der Messung des Betrags und der Phase über alle Raumwinkel $\vartheta$, $\varphi$ ist die Feststellverbindung allerdings angezogen, so dass sich die relative Position der Referenzantenne 2 und der aktiven Antenne 3 zueinander nicht verändern kann.

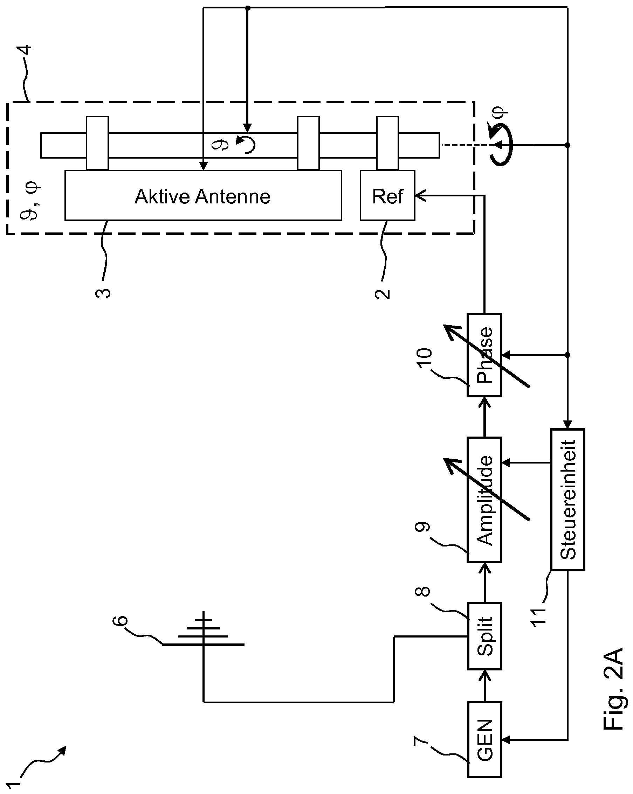

Figur 2A zeigt eine weitere vereinfachte Darstellung der Messeinrichtung 1 und deren zugrunde legenden Aufbau. Wie bereits erläutert, besteht die Messeinrichtung 1 aus einer Dreheinheit 4 sowie einer Referenzantenne 2 und der zu untersuchenden aktiven Antenne 3. Die Messeinrichtung 1 umfasst außerdem noch eine Sendeantenne 6 die von der aktiven Antenne 3 und der Referenzantenne 2 beabstandet angeordnet ist. Die Referenzantenne 2 und die aktive Antenne 3 können, wie die Pfeile in Figur 2A verdeutlichen, gegenüber der Sendeantenne 6 verdreht und/oder verstellt werden. Die Referenzantenne 2 und die aktive Antenne 3 haben dabei stets die gleiche Ausrichtung zueinander. Es ist zusätzlich oder alternativ auch möglich, dass die Sendeantenne 6 gegenüber der aus einer Einheit bestehenden Referenzantenne 2 und aktiven Antenne 3 verdreht und/oder verstellt wird. Beispielsweise kann die Polarisation der Sendeantenne 6 geändert werden. Eine Sendeantenne 6, beispielsweise in Form einer logarithmisch-periodischen Antenne kann dafür um 90° gedreht werden. Die Referenzantenne 2 ist üblicherweise näher an der aktiven Antenne 3 angeordnet als die Sendeantenne 6.

Weiterhin weist die Messeinrichtung 1 einen Signalgenerator 7 auf. Dieser kann ein Sendesignal erzeugen, bei welchem es sich beispielsweise um ein einfaches Sinussignal handeln kann. Der Signalgenerator 7 ist bevorzugt mit einem Leistungsteiler 8 (engl. splitter) verbunden.

Der Leistungsteiler 8 teilt das Eingangssignal, welches er vom Signalgenerator 7 erhält beispielsweise in zwei gleich hohe Ausgangssignale auf. Ein Ausgang des Leistungsteilers ist mit der Sendeantenne 6 verbunden. Ein zweiter Ausgang des Leistungsteilers 8 ist mit der Referenzantenne 2 verbunden.

In dem Ausführungsbeispiel aus Figur 2A sind in dem Signalpfad zwischen dem zweiten Ausgang des Leistungsteilers 8 und der Referenzantenne 2 noch ein Amplitudensteller 9 und ein Phasensteller 10 angeordnet. Bevorzugt ist der zweite Ausgang des Leistungsteilers 8 mit einem Eingang des Amplitudenstellers 9 verbunden. Ein Ausgang des Amplitudenstellers 9 ist mit einem Eingang des Phasenstellers 10 verbunden, wobei ein Ausgang des Phasenstellers 10 mit der Referenzantenne 2 verbunden ist. Die Anordnung des Amplitudenstellers 9 und des Phasenstellers 10 kann auch umgekehrt erfolgen.

Der Amplitudensteller 9 und der Phasensteller 10 können auch in den Signalpfad zwischen dem ersten Ausgang des Leistungsteilers 8 und der Sendeantenne 6 angeordnet sein. Es ist auch möglich, dass der Amplitudensteller 9 und der Phasensteller 10 sowohl im ersten Signalpfad, also zwischen dem ersten Ausgang des Leistungsteilers 8 und der Sendeantenne 6, als auch im zweiten Signalpfad, also zwischen dem zweiten Ausgang des Leistungsteilers 8 und der Referenzantenne 2 angeordnet sind. Es könnte auch der Amplitudensteller 9 und der Phasensteller 10 auf die beiden Signalpfade verteilt werden.

Der Amplitudensteller 9 erlaubt, dass ein ihm zugeführtes Sendesignal in seiner Amplitude erhöht und/oder erniedrigt werden kann. Hierzu weist der Amplitudensteller 9 entweder entsprechende Dämpfungsglieder und/oder entsprechende Verstärkerelemente auf. Der Amplitudensteller 9 ist vorteilhaft aber nicht zwingend notwendig und kann daher auch ganz weggelassen werden.

Der Phasensteller 10 dient dazu, ein ihm am Eingang zugeführtes Sendesignal verzögert an seinem Ausgang auszugeben. Der Phasensteller 10 ist bevorzugt derart ausgebildet, dass ein ihm am Eingang zugeführtes Sendesignal entweder nicht verzögert ausgegeben wird, also dass das Sendesignal an seinem Ausgang im Vergleich zu dem Sendesignal an seinem Eingang eine Phasendifferenz von 0° aufweist. Der Phasensteller 10 ist aber auch in der Lage, dass das Sendesignal an seinem Ausgang im Vergleich zu dem Sendesignal an seinem Eingang eine Phasendifferenz von $\Delta°$, $2\cdot\Delta°$ und/oder $3\cdot\Delta°$ aufweist, wobei $\Delta$ bevorzugt 90 entspricht. Dies bedeutet, dass der Phasensteller 10 ein Sendesignal, welches an seinem Eingang anliegt, um 0°, 90°, 180°, und 270° verschieben kann. Ein solcher Phasensteller 10 kann in analoger HF-Technik aufgebaut werden und beispielsweise Hybride, Inverter und Umschalter beinhalten. Er ist dabei sehr einfach und präzise herstellbar. Der Phasensteller 10 kann auch mit Verzögerungsleitungen aufgebaut sein. Damit ist es möglich, dass Phasendifferenzen von $\Delta°$ einstellbar sind, die beispielsweise im Bereich von 80° bis 100° liegen oder beliebige Werte annehmen können.

Kernpunkt der Messeinrichtung 1 ist die Steuereinheit 11. Die Steuereinheit 11 ist sowohl mit dem Signalgenerator 7, als auch mit dem Amplitudensteller 9, dem Phasensteller 10, der Dreheinheit 4 und der aktiven Antenne 3 verbunden.

Die Steuereinheit 11 ist dabei derart ausgebildet, dass sie den Signalgenerator 7 ansteuern kann, dass dieser ein Sendesignal mit einer bestimmten Frequenz und einer bestimmten Amplitude erzeugt und ausgibt.

Die Steuereinheit 11 ist ebenfalls mit der aktiven Antenne 3 verbunden und kann von dieser die gemessenen Leistungswerte des empfangenen Sendesignals abrufen. Wie bereits erläutert, muss die Steuereinheit 11 nicht zwingend in der Lage sein die gemessenen Phasenwerte von der aktiven Antenne 3 abrufen zu können, weil dies meistens nicht ohne Mitarbeit des Herstellers des aktiven Antennensystems möglich ist.

Die Steuereinheit 11 ist auch mit der Dreheinheit 4 verbunden und kann dieser die einzustellenden Raumwinkel $\vartheta$, $\varphi$ mitteilen.

Weiterhin ist die Steuereinheit 11 mit dem Amplitudensteller 9 verbunden. Die Steuereinheit 11 kann dem Amplitudensteller 9 mitteilen, ob dieser die Amplitude des ihm an seinem Eingang zugeführten Sendesignals erhöhen oder erniedrigen soll. Die Steuereinheit 11 regelt den Amplitudensteller 9 bevorzugt derart, dass die Leistung des Sendesignals von der Sendeantenne 6 an der Position der aktiven Antenne 3 weniger als 20-mal so hoch ist, bevorzugt weniger als zehnmal so hoch ist, weiter bevorzugt weniger als fünfmal so hoch ist, weiter bevorzugt weniger als zweimal so hoch ist, als die Leistung des Sendesignals der Referenzantenne 2 an der Position der aktiven Antenne 3. Der Amplitudensteller 9 kann die Amplitude auch derart einstellen, dass die Leistung des Sendesignals von der Referenzantenne 2 an der Position der aktiven Antenne 3 weniger als 20-mal so hoch ist, bevorzugt weniger als zehnmal so hoch ist, weiter bevorzugt weniger als fünfmal so hoch ist, weiter bevorzugt weniger als zweimal so hoch ist, als die Leistung des Sendesignals der Sendeantenne 6 an der Position der aktiven Antenne 3. Dies bedeutet, dass sich die Leistungen der beiden Sendesignale an der Position der aktiven Antenne 3 um weniger als den Faktor 20, bevorzugt um weniger als den Faktor zehn, weiter bevorzugt um weniger als den Faktor fünf, weiter bevorzugt um weniger als den Faktor zwei, weiter bevorzugt um weniger als den Faktor 1,2 unterscheiden.

Dies gelingt beispielsweise dadurch, dass die Steuereinheit 11 einzig ein Sendesignal über die Sendeantenne 6 aussendet und die von der aktiven Antenne 3 gemessene Leistung abruft. Im nächsten Schritt würde die Steuereinheit 11 das Sendesignal einzig von der Referenzantenne 2 aussenden lassen und ebenfalls die von der aktiven Antenne 3 gemessene Leistung abrufen. Im Anschluss daran würde sie den Amplitudensteller 9, der entweder im Signalpfad zwischen dem Leistungsteiler 8 und der Referenzantenne 2 und/oder im Signalpfad zwischen dem Leistungsteiler 8 und der Sendeantenne 6 angeordnet ist, derart ansteuern, dass die Leistungen beider Sendesignale an der Position der aktiven Antenne 3 in etwa gleich hoch sind.

Die Steuereinheit 11 ist ebenfalls in der Lage den Phasensteller 10 anzusteuern. Die Steuereinheit 11 kann dem Phasensteller 10 vorgeben um wie viel Grad er die Phase zwischen einem Signal, welches ihm an seinem Eingang zugeführt wird und dem Signal, welches er an seinem Ausgang ausgibt, verändern soll. Besonders einfach können Phasenveränderungen von 0°, 90°, 180° und 270° realisiert werden.

Wie später noch erläutert wird, ist es besonders hilfreich, dass das Sendesignal an der Referenzantenne 2 komplett abschaltbar ist, also dass die Sendeantenne 6 als einzige das Sendesignal aussenden kann.

Es ist ebenfalls möglich, dass der Signalgenerator 7, der Leistungsteiler 8 (HF-Splitter), der Amplitudensteller 9 und der Phasensteller 10 in einem gemeinsamen Gerät integriert sind. Dabei kann die Funktion des Amplitudenstellers 9 und/oder des Phasenstellers 10 auch bereits in dem Digitalteil des Basisbandes ausgeführt werden. Wichtig ist, dass die relative Phasenlage der Sendesignale auf den beiden Pfaden, also auf dem Pfad zur Sendeantenne 6 und auf dem Pfad zur Referenzantenne 2, während des gesamten Raumwinkelscans über die Raumwinkel $\vartheta$, $\varphi$ nicht wegdriftet, sondern die eingestellten Phasenwerte bis auf einen gleich bleibenden Offsetwert konstant sind.

Um den gesuchten Betrag und die gesuchte Phase für die aktive Antenne 3 ermitteln zu können gibt es verschiedene Abfolgen. Eine Steuereinheit 11 ist bei gleicher Ausrichtung und Position der aktiven Antenne 3 und der Referenzantenne 2 in Relation zu der Sendeantenne 6 derart ausgebildet und mit der aktiven Antenne 3 und dem Signalgenerator 7 verbunden, dass die nachfolgenden Verfahrensschritte ausführbar sind:

ST1: Alleiniges Aussenden $S_1$ des Sendesignals durch die Sendeantenne 6 und Erfassen $S_{1\_1}$ eines Leistungswerts des durch die aktive Antenne 3 empfangenen Sendesignals;

ST2: Alleiniges Aussenden $S_2$ des Sendesignals durch die Referenzantenne 2 und Erfassen $S_{2\_1}$ eines Leistungswerts des durch die aktive Antenne 3 empfangenen Sendesignals;

ST3: Gleichzeitiges Aussenden $S_3$ des Sendesignals über die Sendeantenne 6 und die Referenzantenne 2 unter Erzeugung von überlagerten Sendesignalen und Erfassen $S_{3\_1}$ eines Leistungswerts der durch die aktive Antenne 3 empfangenen überlagerten Sendesignale.

Die Steuereinheit 11 ist weiterhin dazu ausgebildet, dass eine Abfolge von zumindest drei Verfahrensschritten ST1, ST2, ST3 in beliebiger Reihenfolge und mit beliebiger Kombination, auch unter mehrfacher Durchführung zumindest eines Verfahrensschritts ST1, ST2, ST3 durchgeführt wird, wobei die Abfolge der zumindest drei Verfahrensschritte ST1, ST2, ST3 stets zumindest einmal den Verfahrensschritt ST3 umfasst.

Nachfolgend werden hier exemplarisch drei unterschiedliche Abfolgen a), b) und c) vorgestellt, die sich aus der obigen Kombination ergeben. Innerhalb dieser Abfolgen, die im Weiteren noch genauer beschrieben werden, wird erläutert, wie die Leistungen ermittelt werden, aus denen der gesuchte Betrag und die gesuchte Phase errechnet werden. Es kann auch weitere hier nicht genannte Abfolgen geben. Weiterhin ist es bei dem erfindungsgemäßen Verfahren und bei der erfindungsgemäßen Messeinrichtung 1 vorteilhaft, wenn bei den Abfolgen a) und/oder c) der Amplitudensteller 9 statt oder zusätzlich zum Phasensteller 10 verstellt wird, wobei der Amplitudensteller 9 zwischen dem Signalgenerator 7 und der zumindest einen Sendeantenne 6 und/oder zwischen dem Signalgenerator 7 und der Referenzantenne 2 geschalten ist.

Eine erste Abfolge a) schlägt vor, dass innerhalb der Messung zu Beginn einzig die Sendeantenne 6 oder einzig die Referenzantenne 2 ein Sendesignal aussendet, welches von der aktiven Antenne 3 empfangen wird. Die aktive Antenne 3 übermittelt an die Steuereinheit 11 einen Leistungswert für das empfangene Signal. Dies bedeutet, dass entweder der Verfahrensschritt ST1 oder der Verfahrensschritt ST2 ausgeführt wird. Dabei handelt es sich um den gesuchten Betrag der aktiven Antenne 3, wenn einzig die Sendeantenne 6 gesendet hat. Falls einzig die Referenzantenne 2 das Sendesignal ausgesendet hat, dann kann der gesuchte Betrag zusammen mit den folgenden Messergebnissen, also mit den folgenden Leistungswerten ermittelt werden.

Im Übrigen kann der Leistungswert auch dadurch ermittelt werden, dass beispielsweise eine Datendurchsatzmessung durchgeführt wird. Die Höhe des Datendurchsatzes korreliert dabei mit der Leistung. Wird innerhalb dieser Beschreibung daher von Ermittlung oder Erfassung der Leistung gesprochen, dann kann dies auch über den "Umweg" der Datendurchsatzmessung oder anderer vom Hersteller der aktiven Antenne zur Verfügung gestellter Werte erfolgen.

Im Weiteren senden sowohl die Sendeantenne 6 als auch die Referenzantenne 2 jeweils ein Sendesignal aus. Die aktive Antenne 3 empfängt die kohärente Überlagerung der beiden Sendesignale und liefert einen gemessenen Leistungswert an die Steuereinheit 11. Dieser Sachverhalt ist in dem Verfahrensschritt ST3 zusammengefasst.

Eine solche Messung erfolgt beispielsweise für unterschiedliche Einstellungen des Phasenstellers 10 und/oder des Amplitudenstellers 9. Beispielsweise wird der Phasensteller 10 durch die Steuereinheit 11 derart angesteuert, dass das Signal an seinem Eingang keinen Phasenversatz zu dem Signal an seinem Ausgang aufweist. Für einen bestimmten Raumwinkel $\vartheta$, $\varphi$ gibt die aktive Antenne 3 den Leistungswert der überlagerten Sendesignale an die Steuereinheit 11 aus. Im Anschluss daran wird die Steuereinheit 11 den Phasensteller 10 derart ansteuern, dass dieser die Phase um Δ° bezüglich des Signals an seinem Eingang und des Signals an seinem Ausgang verändert. Es wird abermals zumindest ein gemessener Leistungswert der überlagerten Sendesignale von der aktiven Antenne 3 an die Steuereinheit 11 übermittelt. Der Verfahrensschritt ST3 wird daher mehrfach ausgeführt. Dies passiert solange, bis die Steuereinheit für jeden Raumwinkel $\vartheta$, $\varphi$ mindestens zwei Leistungsmesswerte für zwei unterschiedliche Einstellungen des Phasenstellers 10 und/oder des Amplitudenstellers 9 erhalten hat.

Der Amplitudensteller 9 kann dazu genutzt werden, damit die Leistungen der beiden Sendesignale am Ort der aktiven Antenne 3 in etwa gleich hoch zueinander sind, sich also um weniger als den Faktor 20, bevorzugt um weniger als den Faktor zehn, weiter bevorzugt um weniger als den Faktor fünf, weiter bevorzugt um weniger als den Faktor zwei, weiter bevorzugt um weniger als den Faktor 1,2 unterscheiden. Alternativ kann der Amplitudensteller 9 auch dazu genutzt werden um gezielt die Leistung des Sendesignals an der Sendeantenne 6 und/oder des Sendesignals an der Referenzantenne 2 zu ändern.

Um eine genauere Messung zu erhalten werden bevorzugt drei Messwerte für die Leistung in dem Verfahrensschritt ST3 ermittelt, wobei diese zu drei unterschiedlichen Einstellungen des Phasenstellers 10 und/oder Amplitudenstellers 9 erfolgen.

Mit mindestens drei bekannten Messwerten kann die Phasendifferenz zwischen dem Pfad über die Sendeantenne 6 und dem Pfad über die Referenzantenne 2 bestimmt werden. Bevorzugt wird allerdings zumindest je ein Leistungswert des Empfängers der aktiven Antenne 3 bei vier unterschiedlichen Phasenversätzen gemessen, also der Phasensteller 10 wird derart angesteuert, dass er beispielsweise einen weiteren zusätzlichen Phasenversatz einstellt und damit beispielsweise vier Phasenwerte von 0°, 90°, 180° und 270° eingestellt werden. Daraus ergibt sich die gesuchte Phasendifferenz für den entsprechenden eingestellten Raumwinkel $\vartheta$, $\varphi$. Das gleiche ergibt sich auch für den Einsatz des Amplitudenstellers 9. Dieser kann auch drei oder vier unterschiedliche Amplituden für das Sendesignal an der Sendeantenne 6 und/oder Referenzantenne 2 einstellen.

Für den Fall, dass einzig die Referenzantenne 2 das Sendesignal zu Beginn alleine ausgesendet hat, kann mit der gemessen Leistung für dieses Sendesignal und den zumindest zwei weiteren gemessenen Leistungswerten für das überlagerte Sendesignal, also mit insgesamt drei gemessenen Leistungswerten, auch noch der Betrag des Sendesignals ausgerechnet werden, welches von der Sendeantenne 6 ausgesendet wurde.

Im Anschluss daran steuert die Steuereinheit 11 die Dreheinheit 4 derart an, dass sich ein neuer zu vermessender Raumwinkel $\vartheta$, $\varphi$ ergibt. Für diesen wird ebenfalls der Betrag und die Phase der aktiven Antenne 3 ermittelt.

Der Phasensteller 10 kann natürlich auch andere Phasenwerte einstellen. Wichtig ist nur, dass verschiedene Leistungswerte bei zumindest zwei, besser drei, bevorzugt vier oder mehr verschiedenen Phasenwerten gemessen worden ist. Je weiter die einzelnen Phasenwerte allerdings voneinander beabstandet sind, desto genauer kann die Phase ermittelt werden.

Nachfolgend wird erläutert, wie anhand des gemessenen Betrags, also der gemessenen Leistungswerte, die gesuchten Phasenwerte errechnet werden. Für ein Signal an der aktiven Antenne 3, welche von der Sendeantenne 6 ausgesendet wird gilt:

$$S_S(\vartheta, \varphi) = A_S(\vartheta, \varphi) \cos[\omega t + \gamma(\vartheta, \varphi) + \gamma_{AAS}(t)]$$

mit $A_S(\vartheta, \varphi)$ und $\gamma(\vartheta, \varphi)$, die die gesuchten Amplituden und Phasenwerte darstellen, die für eine Nahfeld-Fernfeld-Transformation benötigt werden. $\omega = 2\pi f$, mit f = Frequenz und $\gamma_{AAS}(t)$ = Phasendrift der aktiven Antenne 3, die sich beispielsweise aufgrund von Erwärmungen der Bauteile oder Jitter einstellen kann.

Für das Signal, welches von der aktiven Antenne 3 empfangen und von der Referenzantenne 2 gesendet wurde gilt:

$$S_{REF,i}(\vartheta, \varphi) = A_{ref}(\vartheta, \varphi) \cos[\omega t + \gamma_i + \gamma_{AAS}(t)]$$

$A_{ref}(\vartheta, \varphi)$ = Amplitude des Sendesignals der Referenzantenne 2, deren Höhe möglichst der Amplitude des Sendesignals $A_S(\vartheta, \varphi)$ der Sendeantenne 6 entspricht, wobei $\gamma_i$ (i = 1,2,3,4) der Einstellung des Phasenstellers 10 entspricht. Die Werte für $\gamma_i$ können nachfolgenden Gleichungen entnommen werden. $\gamma_0$ ist eine Konstante, die aber bereits einen Phasenversatz beinhalten kann. In diesem ist beispielsweise die Kabellänge miteinbezogen. Im Weiteren stellt der Phasensteller 10 keine ($\gamma_1$) oder zusätzliche Phasenverschiebungen von +90° ($\gamma_2$), +180° ($\gamma_3$) und +270° ($\gamma_4$), bezogen auf den Wert $\gamma_0$ ein, der gerade nicht 0° betragen muss.

$$\gamma_1 = \gamma_0 \,, \, \gamma_2 = \gamma_0 + \frac{\pi}{2} \,, \, \gamma_3 = \gamma_0 + \pi \,, \, \gamma_4 = \gamma_0 + \frac{3}{2}\pi$$

Für die kohärente Überlagerung der beiden empfangenen Sendesignale an der aktiven Antenne 3 gilt:

$$S_{AAS,i}(\vartheta, \varphi) = S_S(\vartheta, \varphi) + S_{Ref,i}(\vartheta, \varphi).$$

Die aktive Antenne 3 misst die folgenden Leistungen, wobei der Wert $\gamma_{AAS}(t)$ bei der mathematischen Berechnung herausfällt, was unmittelbar einleuchtend ist, da nur eine Leistung gemessen wird und es hierfür egal ist, wie die Phase "wegläuft", weil diese am Ausgang der aktiven Antenne 3 nicht gemessen wird.

$$P_{AAS,i}(\vartheta, \varphi) = \langle S_{AAS,i}(\vartheta, \varphi)^2 \rangle_t =$$
$$\frac{1}{2}\left[A_S^2(\vartheta, \varphi) + A_{Ref}^2(\vartheta, \varphi)\right] + A_S(\vartheta, \varphi)A_{Ref}(\vartheta, \varphi)\cos[\gamma(\vartheta, \varphi) - \gamma_i]$$

Durch paarweise Kombination ergibt sich

$$P_{AAS,1}(\vartheta, \varphi) - P_{AAS,3}(\vartheta, \varphi) = 2\, A_S(\vartheta, \varphi)A_{Ref}(\vartheta, \varphi)\cos[\gamma(\vartheta, \varphi) - \gamma_0]$$

und

$$P_{AAS,2}(\vartheta, \varphi) - P_{AAS,4}(\vartheta, \varphi) = 2\, A_S(\vartheta, \varphi)A_{Ref}(\vartheta, \varphi)\sin[\gamma(\vartheta, \varphi) - \gamma_0]$$

Für die gesuchten Phasenwerte für die Nahfeld-Fernfeld-Transformation gilt schlussendlich

$$\gamma(\vartheta, \varphi) = \gamma_0 + arctan\left(\frac{P_{AAS,2}(\vartheta,\varphi) - P_{AAS,4}(\vartheta,\varphi)}{P_{AAS,1}(\vartheta,\varphi) - P_{AAS,3}(\vartheta,\varphi)}\right).$$

Wie bereits erläutert, ist es möglich, eine Nahfeld-Fernfeld-Transformation durchzuführen, indem neben der Sendeantenne 6 einzig eine Referenzantenne 2 verwendet wird, wobei in diesem Fall von der aktiven Antenne 3 nur Leistungswerte bezogen werden müssen. Die aktive Antenne 3 muss hierbei keine Phasenwerte ausgeben. Dies erleichtert die Vermessung von aktiven Antennen 3, die von Fremdherstellern stammen.

Die Sendeantenne 6, als auch die Referenzantenne 2 können sowohl ein moduliertes Signal, als auch ein unmoduliertes Sendesignal aussenden. Manche aktive Antennen 3 können beispielsweise nur modulierte Sendesignale verarbeiten. Für den Fall, dass beispielsweise Signale nach dem UMTS Standard mit einer Bandbreite von 5 MHz in Frequenzbändern oberhalb von 500 MHz vorzugsweise oberhalb von 1 GHz verwendet werden, lässt sich das erfindungsgemäße Verfahren unverändert anwenden, wobei für die Nahfeld-Fernfeld-Transformation vorteilhaft der Mittelwert der Sendefrequenzen im 5 MHz Band verwendet wird. Für GSM und auch für LTE bei geeigneter Wahl der verwendeten LTE Resource Blocks (RB) ist die Bandbreite deutlich geringer als bei UMTS, was dazu führt, dass das beschriebene Verfahren für alle im Mobilfunk üblichen Frequenzen anwendbar ist.

Die Phasenwerte, die der Phasensteller 10 einstellt werden möglichst gleichmäßig über 360° verteilt. Beispielsweise kann der Phasensteller 10 Phasenwerte für einen Raumwinkel $\vartheta$, $\varphi$ nacheinander einstellen, die um $\alpha°$ voneinander beabstandet sind, wobei $\alpha° = \dfrac{360°}{Anzahl\ Phasenwerte}$ ist.

Eine zweite Abfolge b) schlägt vor, dass das Sendesignal alleine durch die Sendeantenne 6 ausgesendet wird, wobei die Steuereinheit 11 den Leistungswert des durch die aktive Antenne 3 empfangenen Sendesignals von dieser abruft. Hierbei handelt es sich um den Verfahrensschritt ST1. Im Anschluss daran sendet die Referenzantenne 2 alleine das Sendesignal aus, wobei auch hier wiederum die Steuereinheit 11 den Leistungswert des durch die aktive Antenne 3 empfangenen Sendesignals von dieser empfängt. Dabei handelt es sich um den Verfahrensschritt ST2. Im Anschluss daran senden beide Antennen 2, 6 das Sendesignal gleichzeitig aus, wobei sich beide Sendesignale überlagern. Es wird abermals der empfangene Leistungswert des überlagerten Sendesignals von der aktiven Antenne 3 durch die Steuereinheit 11 abgerufen. Hier handelt es sich um den Verfahrensschritt ST3. Dies erlaubt die Berechnung der Phasendifferenz zwischen dem Sendesignal, das von der Sendeantenne 6 ausgesendet wurde und dem Sendesignal, das von der Referenzantenne 2 ausgesendet wurde. Der Betrag des von der Sendeantenne 6 ausgesendeten Sendesignals wird anhand des gemessenen Leistungswerts aus dem Verfahrensschritt ST1 ermittelt.

Eine dritte Abfolge c) sieht vor dass das Sendesignal sowohl von der Sendeantenne 6, als auch von der Referenzantenne 2 ausgesendet wird, wobei sich beide Sendesignale überlagern. Danach wird der empfangene Leistungswert des überlagerten Sendesignals von der aktiven Antenne 3 durch die Steuereinheit 11 abgerufen. Hierbei handelt es sich um den Verfahrensschritt ST3. Mittels des Phasenstellers 10 wird vorteilhaft eine Phasenveränderung zwischen dem Sendesignal an der Sendeantenne 6 und dem Sendesignal an der Referenzantenne 2 durchgeführt und abermals ein Leistungswert gemessen. Alternativ oder zusätzlich wird mit dem Amplitudensteller 9 die Leistung des Sendesignals der Sendeantenne 6 und/oder die Leistung des Signals der Referenzantenne 2 verändert. Die beschriebene Verstellung des Phasenstellers 10 und/oder Amplitudenstellers 9 und die beschriebene Ermittlung des Leistungswertes wiederholt sich nochmals, bis zumindest drei Leistungswerte erfasst sind, die durch drei unterschiedliche Einstellungen des Phasenstellers 10 und/oder des Amplitudenstellers 9 ermittelt worden sind. Dabei ist es ausreichend, wenn der Phasensteller 10 und der Amplitudensteller 9 das Sendesignal insgesamt dreimal verstellen. Dies bedeutet dass beispielsweise zwei verschiedene Einstellungen des Phasenstellers 10 und eine geänderte Einstellung des Amplitudenstellers 9 ausreichend sind. Anhand der drei gemessenen Leistungswerte werden sowohl der Betrag, als auch die Phase berechnet.

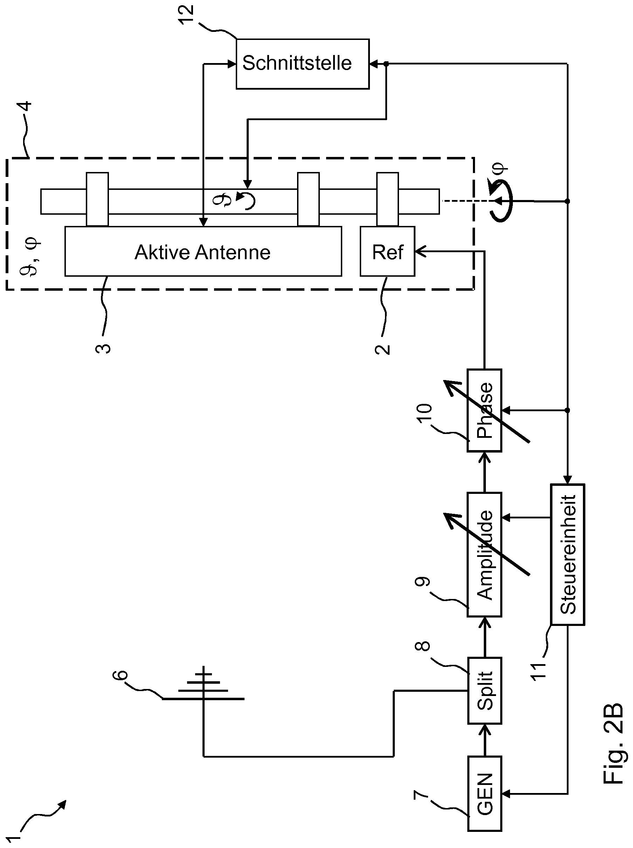

Figur 2B zeigt im Unterschied zu Figur 2A noch ein Schnittstellengerät 12, welches zwischen die aktive Antenne 3 und die Steuereinheit 11 geschalten ist. Das Schnittstellengerät 12 kann beispielsweise die Steuereinheit 11 mit den proprietären Ausgängen der aktiven Antenne 3 verbinden. Das Schnittstellengerät 12 kann auch direkt in die Steuereinheit 11 integriert sein.

Über das Schnittstellengerät 12 ist es möglich, beispielsweise den Empfänger der aktiven Antenne 3, bezüglich dem Start der Software und dem Einstellen des passenden Frequenzbandes zu konfigurieren. Eine Bestimmung der benötigten Leistungsmesswerte, wobei indirekte Messwerte, wie beispielsweise Datendurchsatzmessungen, die ein Spiegelbild der empfangenen Leistung sind, auch denkbar sind, können ebenfalls über das Schnittstellegerät 12 eingestellt werden.

Das Schnittstellengerät 12 muss genau auf den Hersteller der zu untersuchenden aktiven Antenne 3 zugeschnitten sein. Üblicherweise kann vom Hersteller ein solches Schnittstellengerät 12 bezogen werden, das mit der aktiven Antenne 3 kommunizieren kann. Üblicherweise kann dieses Schnittstellengerät Messwerte weitergeben, die direkt die gemessene Empfangsleistung darstellen oder aus denen indirekt auf die Empfangsleistung rückgeschlossen werden kann.

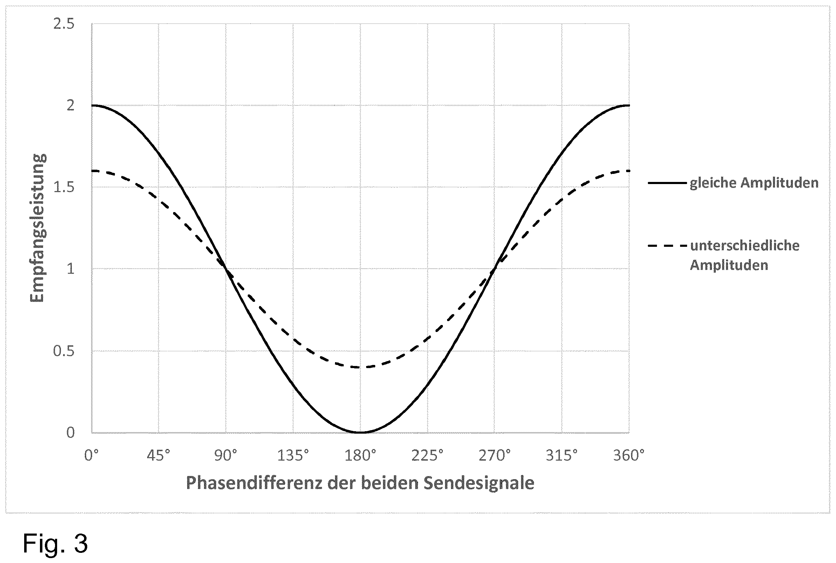

Figur 3 zeigt eine Darstellung, die die Überlagerung der Sendesignale verdeutlicht, wobei die überlagerten Sendesignale einmal die gleiche Amplitude haben und einmal nicht. Aufgetragen ist auf der Abszisse die Phasendifferenz der beiden empfangenen Sendesignale und auf der Ordinate die empfangene Leistung durch die aktive Antenne 3. Mit durchgezogener Linie sind zwei überlagerte Sendesignale dargestellt, die an der Position der aktiven Antenne 3 die gleichen Amplituden aufweisen. Zu sehen ist, dass bei einer Phasendifferenz der beiden Sendesignale an der Position der aktiven Antenne 3 von 180° sich beide Sendesignale auslöschen und die aktive Antenne 3 keine Leistung empfängt. Bei einer Phasenverschiebung von 0° dagegen addieren sich die beiden Sendesignale und die aktive Antenne 3 misst die doppelte Leistung. Problematisch ist der Fall, wenn die beiden Sendesignale an der Position der aktiven Antenne 3 stark unterschiedliche Amplituden aufweisen. Die gestrichelte Linie in Figur 3 zeigt den Fall, dass sich die beiden Leistungen um den Faktor 9 unterscheiden. In diesem Fall wird auch bei einer Phasendifferenz von 180° noch eine nennenswerte Leistung durch die aktive Antenne 3 empfangen. Für den Fall, dass die beiden Sendesignale an der Position der aktiven Antenne 3 stark unterschiedliche Amplituden aufweisen kann die Genauigkeit bei der Berechnung der Phasendifferenz nachlassen. Dabei sollte die Steuereinheit 11 stets versuchen den Amplitudensteller 9 derart anzusteuern, dass das Sendesignal der Sendeantenne 6 und das Sendesignal der Referenzantenne 2 an der Position der aktiven Antenne 3 möglichst in etwa die gleiche Amplitude aufweist.

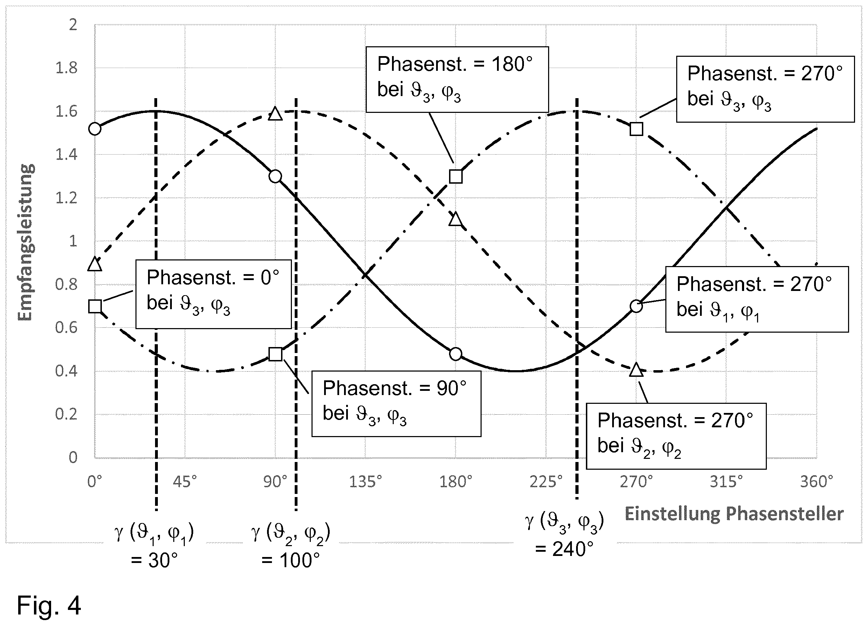

Figur 4 zeigt eine Darstellung die verschiedene überlagerte Sendesignale als Funktion der Einstellung des Phasenstellers zeigt und verdeutlicht, wie die Phasendifferenz für jedes überlagerte Sendesignal ermittelt wird. In Figur 4 werden drei überlagerte Sendesignale gezeigt, wie sie an dem Ort der aktiven Antenne 3 gemessen werden können. Das erste überlagerte Sendesignal wurde aufgenommen, als die aktive Antenne 3 mit dem Raumwinkel $\vartheta_1$ und $\varphi_1$ ausgerichtet war. Dieses überlagerte Sendesignal ist mit einer durchgezogenen Linie dargestellt. Ein weiteres überlagertes Sendesignal wurde bei dem Raumwinkel $\vartheta_2$ und $\varphi_2$ aufgenommen. Dieses weitere überlagerte Sendesignal ist mit einer gestrichelten Linie dargestellt. Ein drittes überlagertes Sendesignal wurde bei einem Raumwinkel $\vartheta_3$ und $\varphi_3$ aufgenommen. Dieses dritte überlagerte Sendesignal ist mit einer gestrichelten und gepunkteten Linie dargestellt.

Um für jeden dieser Raumwinkel die gesuchte Phasendifferenz $\gamma$ bestimmen zu können wurden jeweils vier Leistungswerte gemessen. Ein erster Leistungswert wurde gemessen, als der Phasensteller 10 keine zusätzliche Phasenverschiebung zwischen dem Signal an seinem Eingang und an seinem Ausgang eingestellt hat. Ein zweiter Leistungswert wurde für jedes dieser überlagerten Sendesignale gemessen, als der Phasensteller 10 eine Phasenverschiebung von zusätzlich 90° eingestellt hat. Ein dritter Leistungswert wurde ermittelt, als der Phasensteller 10 einen Phasenversatz von zusätzlich 180° eingestellt hat. Ein vierter und letzter Leistungswert wurde für jedes dieser überlagerten Sendesignale ermittelt, als der Phasensteller 10 einen zusätzlichen Phasenversatz von 270° eingestellt hat. Diese Messwerte sind mit Kreisen, Dreiecken oder Vierecken innerhalb von Figur 4 hervorgehoben. Anhand dieser Messerwerte und der Tatsache, dass das gesuchte Sendesignal einen kosinusförmigen Verlauf aufweist, konnten die gesuchten Phasenwerte $\gamma$ berechnet werden. Aufgrund von leichten Messungenauigkeiten besteht ein vorteilhaftes mathematisches Berechnungsverfahren darin, ein kosinusförmiges Signal derart an die gemessenen Leistungswerte anzunähern, dass dieses zu allen Punkten den geringsten Abstand aufweist. Dies gelingt beispielsweise durch die mathematische Methode "Minimum der Summe der quadratischen Abweichungen".

Zu erkennen ist, dass das erste überlagerte Sendesignal mit dem Raumwinkel $\vartheta_1$ und $\varphi_1$ einen Phasenversatz von 30° gegenüber der Kosinusfunktion aufweist. Daraus kann geschlossen werden, dass das von der aktiven Antenne 3 empfangene Sendesignal von der Sendeantenne 6 gegenüber dem empfangenen Sendesignal von der Referenzantenne 2 um 30° verschoben ist und das ist genau die gesuchte Phasenverschiebung beim Raumwinkel $\vartheta_1$ und $\varphi_1$. Das von der Referenzantenne 2 gesendete Signal darf sich allerdings nicht gegenüber dem von der Sendeantenne 6 gesendeten ändern, sondern muss für alle eingestellten Phasenwerte das Gleiche sein, was bedeutet, dass der Raumwinkel während der Messschritte nicht geändert werden darf und auch die relative Phasenbeziehung der beiden HF-Signale, die zur Sendeantenne 6 und zur Referenzantenne 2 geschickt werden genau dem eingestellten Phasenoffset entsprechen müssen.

Das zweite überlagerte Sendesignal mit dem Raumwinkel $\vartheta_2$ und $\varphi_2$ weist einen Phasenversatz von 100° auf. Das dritte überlagerte Sendesignal mit dem Raumwinkel $\vartheta_3$ und $\varphi_3$ weist einen Phasenversatz von 240° auf.

Nachdem ein Phasenversatz ermittelt worden ist, steuert die Steuereinheit 11 die Dreheinheit 4 derart an, dass ein weiterer Raumwinkel eingestellt wird. Für diesen werden im Anschluss ebenfalls der Betrag und der Phasenversatz ermittelt. Diese Werte werden dann für die Nahfeld-Fernfeld-Transformation verwendet.

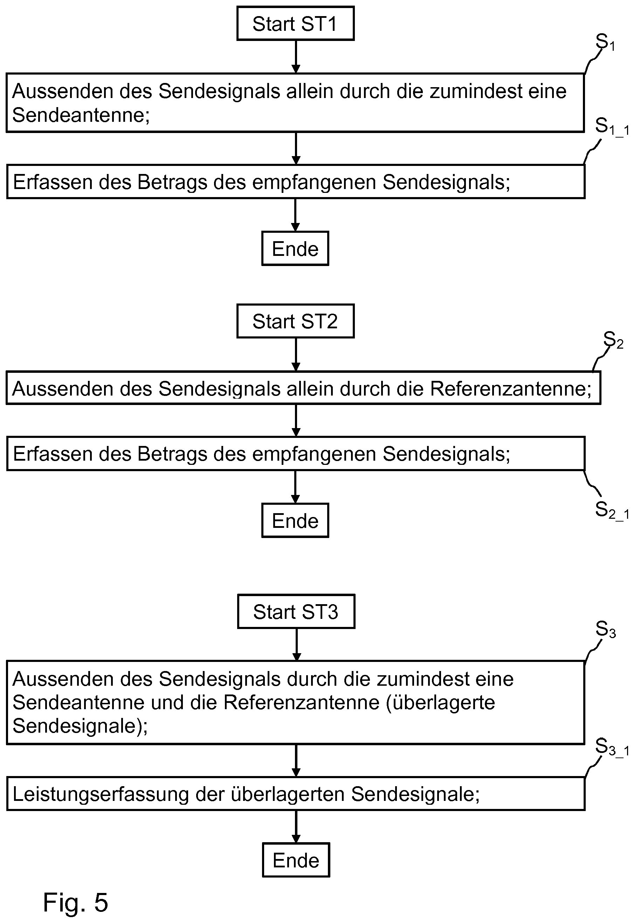

Figur 5 zeigt mehrere Ablaufdiagramme, welche die Verfahrensschritte ST1, ST2 und ST3 näher erläutern. Diese Verfahrensschritte ST1, ST2 und ST3 sind der Grundstein um den gesuchten Betrag und die gesuchte Phase für die Aktive Antenne 3 ermitteln zu können. Dabei sind verschiedene Kombinationen dieser Verfahrensschritte ST1, ST2 und ST3 möglich, die auch als Abfolge bezeichnet werden. Innerhalb des Verfahrensschritts ST1 erfolgt ein alleiniges Aussenden $S_1$ des Sendesignals durch die Sendeantenne 6 und ein Erfassen $S_{1\_1}$ eines Leistungswerts des durch die aktive Antenne 3 empfangenen Sendesignals. Innerhalb des Verfahrensschritts ST2 erfolgt ein alleiniges Aussenden $S_2$ des Sendesignals durch die Referenzantenne 2 und ein Erfassen $S_{2\_1}$ eines Leistungswerts des durch die aktive Antenne 3 empfangenen Sendesignals. Innerhalb des Verfahrensschritts ST3 erfolgt dagegen ein gleichzeitiges Aussenden $S_3$ des Sendesignals über die Sendeantenne 6 und die Referenzantenne 2 unter Erzeugung von überlagerten Sendesignalen und ein Erfassen $S_{3\_1}$ eines Leistungswerts der durch die aktive Antenne 3 empfangenen überlagerten Sendesignale.

Dabei ist wichtig, dass eine Abfolge dieser drei Verfahrensschritte ST1, ST2 und ST3 in beliebiger Reihenfolge und mit beliebiger Kombination, auch unter mehrfacher Durchführung zumindest eines Verfahrensschritts ST1, ST2, ST3 durchgeführt wird, wobei die Abfolge der zumindest drei Verfahrensschritte ST1, ST2, ST3 stets zumindest einmal den Verfahrensschritt ST3 umfasst. Die Verfahrensschritte ST1 und ST2 müssen in einer Abfolge nicht zwingend ausgeführt werden.

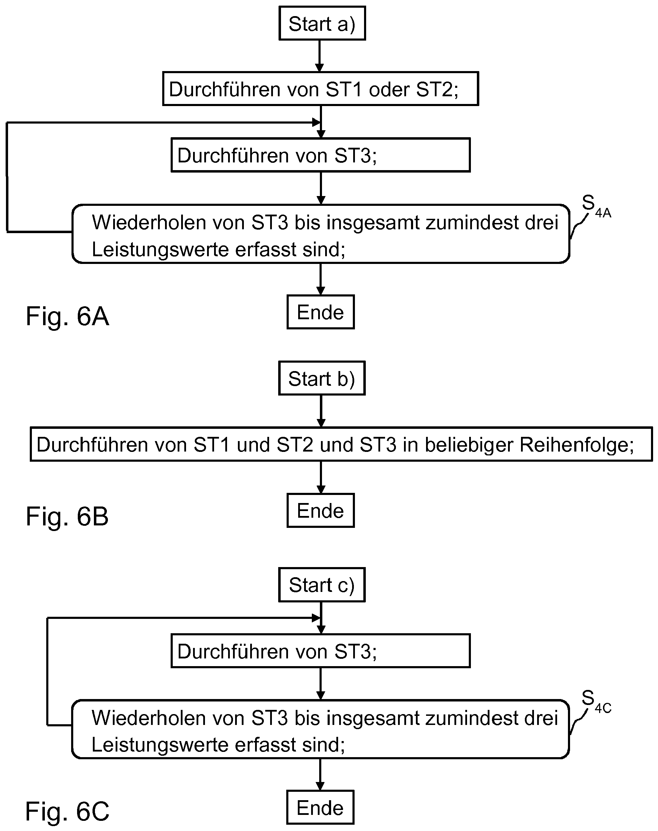

Figur 6A zeigt ein Ablaufdiagramm zur Bestimmung der Leistungswerte eines durch die aktive Antenne empfangenen Signals gemäß der Abfolge a). Zu Beginn wird entweder der Verfahrensschritt ST1 oder der Verfahrensschritt ST2 einmal ausgeführt. Davor oder im Anschluss daran wird der Verfahrensschritt ST3 ausgeführt. Nachdem der Verfahrensschritt ST3 ausgeführt wurde wird der Verfahrensschritt $S_{4A}$ ausgeführt. Innerhalb des Verfahrensschritts $S_{4A}$ wird der Verfahrensschritt ST3 derart oft wiederholt, bis zumindest drei Leistungswerte vorliegen. Hierzu muss der Verfahrensschritt ST3 zumindest zweimal ausgeführt werden.

Figur 6B zeigt ein Ablaufdiagramm zur Bestimmung der Leistungswerte eines durch die aktive Antenne empfangenen Signals gemäß der Abfolge b). Es werden die Verfahrensschritte ST1, ST2 und ST3 in beliebiger Reihenfolge zumindest einmal ausgeführt.

Figur 6C zeigt ein Ablaufdiagramm zur Bestimmung der Leistungswerte eines durch die aktive Antenne empfangenen Signals gemäß der Abfolge c). Es wird einzig der Verfahrensschritt ST3 ausgeführt. Nachdem der Verfahrensschritt ST3 ausgeführt wurde, wird der Verfahrensschritt $S_{4C}$ ausgeführt. Innerhalb des Verfahrensschritts $S_{4C}$ wird der Verfahrensschritt ST3 derart oft wiederholt, bis zumindest drei Leistungswerte vorliegen. Hierzu muss der Verfahrensschritt ST3 zumindest dreimal ausgeführt werden.

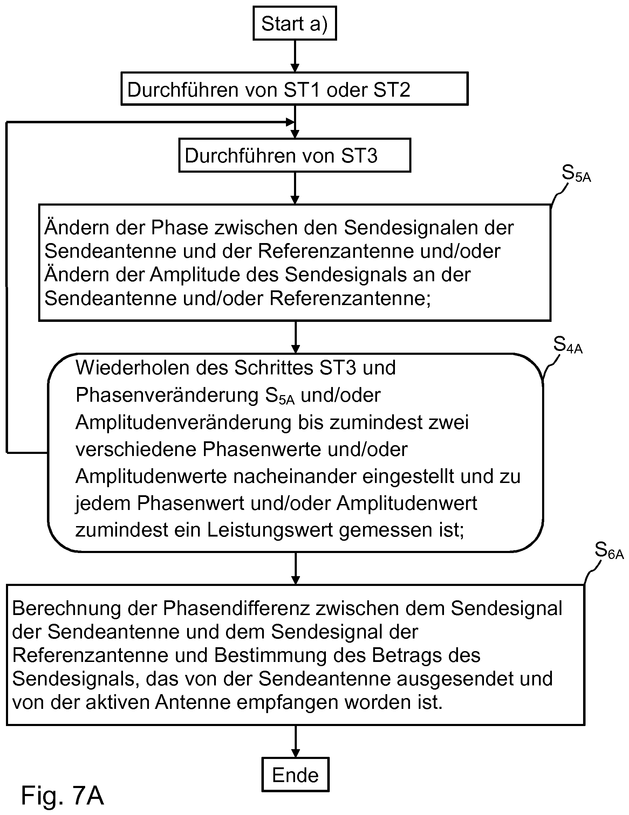

Figur 7A zeigt ein Ablaufdiagramm zur Bestimmung der Leistungswerte zur Berechnung von Betrag und Phase eines durch die aktive Antenne 3 empfangenen Sendesignals mittels der Abfolge a). In einem ersten Verfahrensschritt $S_1$ oder $S_2$ wird ein Sendesignal einzig durch die Sendeantenne 6 oder einzig durch die Referenzantenne 2 ausgesendet. Bei dem Sendesignal kann es sich beispielsweise um ein sinusförmiges oder kosinusförmiges Signal handeln.

In einem weiteren Verfahrensschritt $S_{1\_1}$ oder $S_{2\_1}$ wird das von der Sendeantenne 6 oder Referenzantenne 2 ausgesendete Signal durch die aktive Antenne 3 erfasst. Diese Verfahrensschritte $S_1$ und $S_{1\_1}$ oder $S_2$ und $S_{2\_1}$ werden durch den Verfahrensschritt ST1 oder ST2 dargestellt. Die aktive Antenne 3 übermittelt den Leistungswert und damit den Betrag des empfangenen Sendesignals an die Steuereinheit 11. Der Leistungswert wird direkt oder indirekt erfasst. Bei einer indirekten Erfassung der Leistung kann beispielsweise der Datendurchsatz erfasst werden, der wiederum mit der empfangenen Leistung korreliert, sodass diese daraus berechnet werden kann.

In dem Verfahrensschritt $S_3$ senden sowohl die Sendeantenne 6, als auch die Referenzantenne 2 gleichzeitig ein Sendesignal aus, welches an der Position der aktiven Antenne 3 als überlagertes Sendesignal vorliegt.

Innerhalb des Verfahrensschritts $S_{3\_1}$ wird durch die aktive Antenne 3 die Leistung der überlagerten Sendesignale erfasst und an die Steuereinheit 11 ausgegeben.

Diese beiden Verfahrensschritte $S_3$ und $S_{3\_1}$ sind Teil des Verfahrensschritts ST3.

Im weiteren Verfahrensschritt $S_{5A}$ führt der Phasensteller 10 eine Änderung der Phase zwischen dem Sendesignal der Sendeantenne 6 und dem Sendesignal der Referenzantenne 2 durch. Alternativ oder zusätzlich ist es auch möglich, dass der Amplitudensteller 9 eine Amplitudenveränderung des Sendesignals an der Sendeantenne 6 und/oder des Sendesignals an der Referenzantenne 2 vornimmt.

Im Anschluss daran wird der Verfahrensschritt $S_{4A}$ ausgeführt. Innerhalb des Verfahrensschritts $S_{4A}$ werden die vorherigen Verfahrensschritte ST3 und Phasenveränderung $S_{5A}$ und/oder Amplitudenveränderung derart oft nacheinander ausgeführt, bis für zumindest zwei unterschiedliche Phasenwerte zwischen dem Sendesignal an der Sendeantenne 6 und dem Sendesignal an der Referenzantenne 2 und/oder bis für zumindest zwei unterschiedliche Amplitudenwerte des Sendesignals an der Sendeantenne 6 und/oder des Sendesignals an der Referenzantenne 2 zumindest je ein Leistungswert erfasst ist. Dies bedeutet, dass der Phasensteller 10 zumindest einmal eine Phasenänderung zwischen dem Signal an seinem Eingang und dem Signal an seinem Ausgang durchführen muss, damit insgesamt zumindest zwei Signale ausgegeben werden, die eine unterschiedliche Phase aufweisen. Gleiches gilt ebenfalls für den Amplitudensteller 9. Bevorzugt wird der Verfahrensschritt $S_{4A}$ jedoch so oft ausgeführt, bis mindestens je ein Leistungswert für zumindest drei, besser vier oder mehr unterschiedliche Phasenwerte und/oder Amplitudenwerte gemessen ist.

Im Anschluss daran wird der Verfahrensschritt $S_{6A}$ ausgeführt. Innerhalb des Verfahrensschritts $S_{6A}$ wird die gesuchte Phasendifferenz zwischen dem Sendesignal der Sendeantenne 6 und dem Sendesignal der Referenzantenne 2 anhand der gemessenen zumindest drei Leistungswerte berechnet, wobei die beiden Sendesignale von der aktiven Antenne 3 empfangen werden. Ein erster Leistungswert wurde dabei im Verfahrensschritt ST1 oder ST2 ermittelt. Die beiden weiteren Leistungswerte in dem Verfahrensschritt ST3, der zumindest zweimal für unterschiedliche Phaseneinstellungen ausgeführt wurde.

Dieser Sachverhalt ist beispielsweise sehr gut in Figur 4 und in den weiter oben dargestellten mathematischen Beziehungen dargestellt. Wenn nur der Verfahrensschritt ST1 durchgeführt wurde und daher die Sendeantenne 6 das Signal ausgesendet hat, entspricht dieser Leistungswert dem gesuchten Betrag. Wenn stattdessen der Verfahrensschritt ST2 ausgeführt wurde und daher die Referenzantenne 2 das Signal ausgesendet hat, dann kann der gesuchte Betrag aus den zumindest drei beschriebenen Leistungswerten berechnet werden.

Selbstverständlich kann auch mit dem Verfahrensschritt ST3 begonnen werden. Die Verfahrensschritte ST1 oder ST2 können beispielsweise auch nach dem Verfahrensschritt $S_{4A}$ ausgeführt werden. Dies bedeutet, dass alle Schritte, die die Messung eines Sendesignals beinhalten vertauscht zueinander ausgeführt werden können. Dies gilt für das Aussenden von einem Sendesignal oder von mehreren Sendesignalen und die gleichzeitige Messung der Leistung dieses oder dieser Sendesignale. Die abschießende Berechnung der Phase oder des Betrags, wenn beispielsweise nur die Referenzantenne 2 alleine sendet, erfolgt zum Schluss, also nachdem für einen Raumwinkel $\vartheta$, $\varphi$ die Sendesignale ausgesendet und die Leistungswerte gemessen worden sind. Dies gilt für alle Abfolgen a), b) und c).

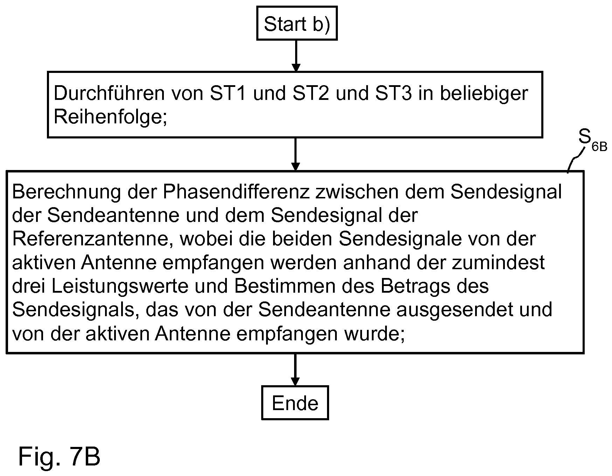

Figur 7B zeigt ein weiteres Ablaufdiagramm zur Bestimmung von Leistungswerten zur Berechnung von Betrag und Phase eines durch die aktive Antenne 3 empfangenen Sendesignals mittels der Abfolge b). In einem ersten Verfahrensschritt $S_1$ wird ein Sendesignal einzig durch die Sendeantenne 6 ausgesendet.

In einem weiteren Verfahrensschritt $S_{1\_1}$ wird der Betrag des durch die aktive Antenne 3 empfangenen Sendesignals erfasst.

Diese beiden Verfahrensschritte $S_1$ und $S_{1\_1}$ stellen den Verfahrensschritt ST1 dar.

In dem Verfahrensschritt $S_2$ wird das Sendesignal einzig durch die Referenzantenne 2 ausgesendet.

Im Weiteren wird der Verfahrensschritt $S_{2\_1}$ ausgeführt und erneut der Betrag des durch die aktive Antenne 3 empfangenen Sendesignals erfasst.

Diese beiden Verfahrensschritte $S_2$ und $S_{2\_1}$ sind Teil des Verfahrensschritts ST2.

Im Verfahrensschritt $S_3$ wird durch die Sendeantenne 6 und durch die Referenzantenne 2 gleichzeitig ein Sendesignals aussendet, was zu einem überlagerten Sendesignals führt.

In dem Verfahrensschritt $S_{3\_1}$ wird eine Leistungserfassung des durch die aktive Antenne 3 empfangenen überlagerten Sendesignals durchgeführt.

Diese beiden Verfahrensschritte $S_3$ und $S_{3\_1}$ sind Teil des Verfahrensschritts ST3.

Im Anschluss daran wird im Verfahrensschritt $S_{6B}$ eine Phasendifferenz an der aktiven Antenne 3 zwischen dem Sendesignal, das von der Sendeantenne 6 ausgesendet wurde und dem Sendesignal, das von der Referenzantenne 2 ausgesendet wurde, berechnet. Der Betrag wird anhand des Leistungswerts aus dem Verfahrensschritt ST1 ermittelt.

Selbstverständlich können die Verfahrensschritte ST1, ST2 und ST3 beliebig in der Reihenfolge vertauscht werden. Ein Phasensteller 10 wird hier nicht benötigt, allerdings kann dieser zur Verbesserung der Genauigkeit dennoch eingesetzt werden. Das gleiche gilt für den Einsatz eines Amplitudenstellers 9.

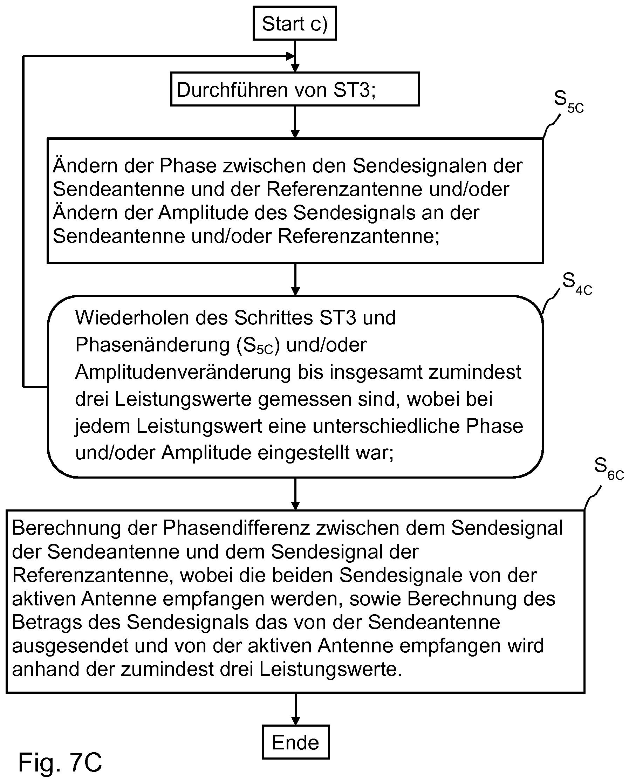

Figur 7C zeigt ein weiteres Ablaufdiagramm zur Bestimmung von Leistungswerten zur Berechnung von Betrag und Phase eines durch die aktive Antenne 3 empfangenen Sendesignals mittels der Abfolge c). In einem ersten Verfahrensschritt $S_3$ wird ein Sendesignal gleichzeitig durch die Sendeantenne 6 und die Referenzantenne 2 ausgesendet.

In einem weiteren Verfahrensschritt $S_{3\_1}$ wird eine Leistungserfassung des durch die aktive Antenne 3 empfangenen überlagerten Sendesignals durchgeführt.

Diese beiden Verfahrensschritte $S_3$ und $S_{3\_1}$ sind Teil des Verfahrensschritts ST3.

Im weiteren Verfahrensschritt $S_{5C}$ führt der Phasensteller 10 eine Änderung der Phase zwischen dem Sendesignal der Sendeantenne 6 und dem Sendesignal der Referenzantenne 2 durch. Alternativ oder zusätzlich ist es auch möglich, dass der Amplitudensteller 9 eine Amplitudenveränderung des Sendesignals an der Sendeantenne 6 und/oder des Sendesignals an der Referenzantenne 2 vornimmt.

Im Anschluss daran wird der Verfahrensschritt $S_{4C}$ ausgeführt. Innerhalb des Verfahrensschritts $S_{4C}$ werden die vorherigen Verfahrensschritte ST3 und Phasenveränderung $S_{5C}$ und/oder Amplitudenveränderung derart oft ausgeführt, bis für zumindest drei unterschiedliche Phasenwerte zwischen dem Sendesignal an der Sendeantenne 6 und dem Sendesignal an der Referenzantenne 2 und/oder bis für zumindest drei unterschiedliche Amplitudenwerte des Sendesignals an der Sendeantenne 6 und/oder des Sendesignals an der Referenzantenne 2 zumindest je ein Leistungswert erfasst ist. Dies bedeutet, dass der Phasensteller 10 zumindest zweimal eine Phasenänderung zwischen dem Signal an seinem Eingang und dem Signal an seinem Ausgang durchführen muss, damit insgesamt zumindest drei Signale ausgegeben werden, die eine unterschiedliche Phase aufweisen. Gleiches gilt ebenfalls für den Amplitudensteller. Bevorzugt wird der Verfahrensschritt $S_{4C}$ jedoch so oft ausgeführt, bis mindestens je ein Leistungswert für zumindest vier oder mehr unterschiedliche Phasenwerte und/oder Amplitudenwerte gemessen ist.

Im Anschluss daran wird der Verfahrensschritt $S_{6C}$ ausgeführt. Innerhalb des Verfahrensschritts $S_{6C}$ wird die gesuchte Phasendifferenz zwischen dem Sendesignal der Sendeantenne 6 und dem Sendesignal der Referenzantenne 2 anhand der gemessenen zumindest drei Leistungswerte berechnet, wobei die beiden Sendesignale von der aktiven Antenne 3 empfangen werden. Gleiches gilt auch für die Berechnung des Betrags des Sendesignals, das von der Sendeantenne 6 ausgesendet wurde.

Die Genauigkeit der Verfahren aus den Figuren 7B und 7C ist allerdings nicht so hoch, wie die aus dem Verfahren von Figur 7A. Daher kann bei diesen Verfahren zusätzlich eine weitere Messung durchgeführt werden, wo nur die Sendeantenne 6 oder nur die Referenzantenne 2 oder beide Antennen 2, 6 gemeinsam, mit einer geänderten Phaseneinstellung, ein Sendesignal aussenden. Weiterhin kann es sinnvoll sein, wenn die Sendeleistung durch den Amplitudensteller 9 zwischen den einzelnen Messungen geändert wird, sodass der Betrag und die Phase für einen Raumwinkel $\vartheta$, $\varphi$ bei unterschiedlichen Sendeleistungen für die Sendeantenne 6 und/oder die Referenzantenne 2 erfolgt, wobei die Höhe der Änderung in der Sendeleistung bekannt sein muss.

Die Genauigkeit kann auch dadurch erhöht werden, dass Werte von Betrag und Phase, die für unterschiedliche Raumwinkel $\vartheta$, $\varphi$ ermittelt worden sind, miteinander verglichen werden. Dies gelingt, indem man die Stetigkeit der berechneten Werte für Betrag und Phase bei nur kleinen Änderungen der Raumwinkel $\vartheta$, $\varphi$ ausnützt.

Für den Fall, dass die Amplitude und die Phase für einen Raumwinkel $\vartheta$, $\varphi$ gemäß einem der Abfolgen a), b) oder c) gemessen worden ist, ist es auch ausreichend, wenn für die anderen Raumwinkel $\vartheta$, $\varphi$ nur zwei Messungen mit einem überlagerten Sendesignal durchgeführt werden, also wenn für jeden neuen Raumwinkel einzig die Sendeantenne 6 und die Referenzantenne 2 gemeinsam ein Sendesignal aussenden, wobei der Phasensteller 10 einmalig die Phase ändern muss. Durch die vollständige Messung des ersten Raumwinkels $\vartheta$, $\varphi$ ist der Wert für die Leistung, die direkt von der Referenzantenne 2 in die aktive Antenne 3 einkoppelt, bekannt. An dieser Leistung wird nichts geändert und auch die Ausrichtung der Referenzantenne 2 in Bezug zur aktiven Antenne 3 ändert sich nicht. Alternativ dazu ist es ebenfalls möglich, wenn in den Messungen für die weiteren Raumwinkel $\vartheta$, $\varphi$ für jeden weiteren Raumwinkel $\vartheta$, $\varphi$ nur die Sendeantenne 6 alleine das Sendesignal aussendet und einmalig die Sendeantenne 6 und die Referenzantenne 2 zusammen ein Sendesignal aussenden. Allerdings wird die Messung hier ungenauer. Die Messzeit verkürzt sich allerdings.

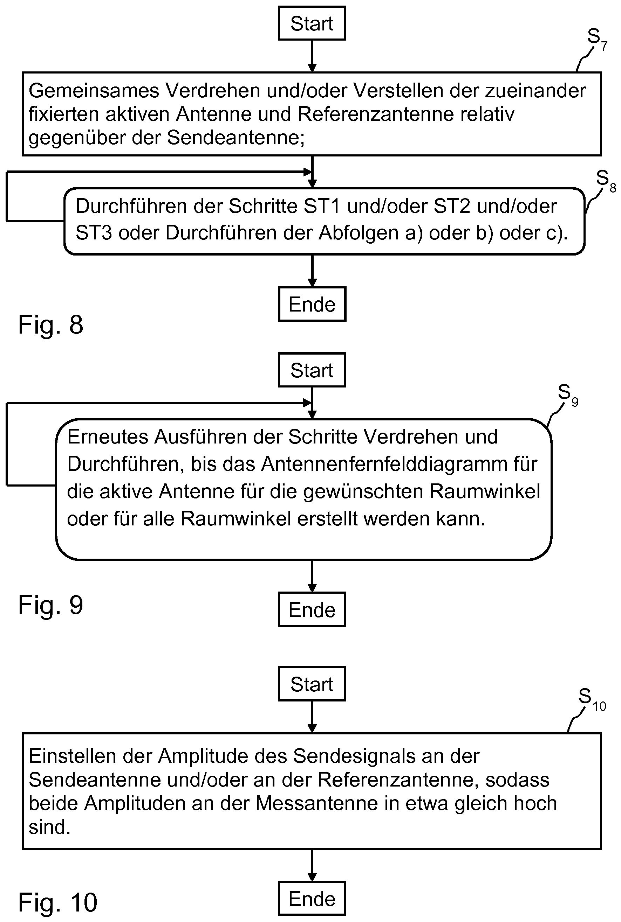

Figur 8 zeigt ein weiteres Ablaufdiagramm, welches die Veränderung des Azimutwinkels $\varphi$ und des Elevationswinkels $\vartheta$ erläutert, um den Betrag und die Phase eines durch die aktive Antenne 3 empfangenen Signals für mehrere Raumwinkel erfassen zu können. Nachdem sowohl der Betrag als auch die Phase für einen Raumwinkel $\vartheta$, $\varphi$ berechnet worden sind, wird der Verfahrensschritt $S_7$ ausgeführt. Innerhalb des Verfahrensschritts $S_7$ steuert die Steuereinheit 11 die Dreheinheit 4 derart an, dass diese die eine Einheit bildende Referenzantenne 2 und die aktive Antenne 3 gemeinsam gegenüber der stationären, also ortsfest ausgebildeten Sendeantenne 6 verdreht und/oder verstellt. Dabei kann die Dreheinheit 4 sowohl den Azimutwinkel $\varphi$ als auch den Elevationswinkel $\vartheta$ verändern. Nachdem ein neuer Raumwinkel eingestellt worden ist, wird der Verfahrensschritt $S_8$ ausgeführt. Innerhalb des Verfahrensschritts $S_8$ werden die vorherigen Verfahrensschritte ST1 und/oder ST2 und/oder ST3 oder eine der Abfolgen a) oder b) oder c) erneut ausgeführt.

Figur 9 zeigt ein weiteres Ablaufdiagramm, welches erläutert, wie die weiteren Beträge und Phasen, die für die Berechnung des Antennenfernfelddiagramms notwendig sind, ermittelt werden. Innerhalb des Verfahrensschritts $S_9$

werden die Verfahrensschritte $S_7$ und $S_8$ derart oft durchgeführt, bis die Werte für Betrag und Phase für die gewünschten Raumwinkel $\vartheta$, $\varphi$ oder für alle Raumwinkel $\vartheta$, $\varphi$ ermittelt worden sind. Danach kann die Nahfeld-Fernfeld-Transformation für einen Teil der Raumwinkel der aktiven Antenne 3 oder für die gesamten Raumwinkel der aktiven Antenne 3 durchgeführt werden. Bei den gewünschten Raumwinkeln $\vartheta$, $\varphi$ kann es sich beispielsweise um diese handeln, in die die aktive Antenne 3 besonders gut abstrahlt, also beispielsweise diese in denen die Hauptkeule liegt. Weiter bevorzugt kann das Antennenfernfelddiagramm auch für die Raumwinkel $\vartheta$, $\varphi$ berechnet werden, in denen sich die Nebenkeulen mit der höchsten Intensität ausbilden.

Figur 10 zeigt ein weiteres Ablaufdiagramm, welches die Anpassung der Amplitude des Sendesignals der Sendeantenne 6 an die Amplitude des Sendesignals der Referenzantenne 2 oder umgekehrt beschreibt. Hierzu wird der Verfahrensschritt $S_{10}$ ausgeführt. Innerhalb des Verfahrensschritts $S_{10}$ steuert die Steuereinheit 11 einen Amplitudensteller 9 derart an, dass ein Signal, welches dem Eingang des Amplitudenstellers 9 zugeführt wird, in seiner Amplitude entweder verstärkt oder gedämpft an dessen Ausgang ausgegeben wird. Der Amplitudensteller 9 kann sowohl in dem Signalpfad zwischen dem zweiten Ausgang des Leistungsteilers 8 und der Referenzantenne 2, als auch im Signalpfad zwischen dem ersten Ausgang des Leistungsteilers 8 und der Sendeantenne 6 eingebracht werden. Das Ziel ist dabei, dass die Amplitude des Sendesignals, welches von der Sendeantenne 6 ausgesendet wird, und die Amplitude des Sendesignals, welches von der Referenzantenne 2 ausgesendet wird, am Ort der aktiven Antenne 3 in etwa gleich hoch sind.

Innerhalb des Verfahrensschritts $S_{10}$ wird daher bevorzugt abwechselnd ein Signal einzig durch die Sendeantenne 6 gesendet und dessen Leistung durch die aktive Antenne 3 erfasst. Im Anschluss wird ein Signal einzig durch die Referenzantenne 2 ausgesendet und abermals dessen Leistung durch die aktive Antenne 3 erfasst. Im Anschluss daran wird die Höhe der Amplitude des Sendesignals, welches durch die Sendeantenne 6 und/oder welches durch die Referenzantenne 2 ausgesendet wird, erhöht und/oder erniedrigt, sodass beide Sendesignale, die sich am Ort der aktiven Antenne 3 überlagern, in etwa gleich hoch sind. Unter dem Begriff in etwa gleich hoch wird eine Abweichung verstanden, bei der sich die beiden Leistungen um weniger als den Faktor 20, bevorzugt um weniger als den Faktor zehn, weiter bevorzugt um weniger als den Faktor fünf, weiter bevorzugt um weniger als den Faktor zwei, weiter bevorzugt um weniger als den Faktor 1,2 unterscheiden.

Der Verfahrensschritt $S_{10}$ kann beispielsweise einmalig vor dem Ausführen des Verfahrensschritts ST1 oder ST2 oder ST3 ausgeführt werden. Der Verfahrensschritt $S_{10}$ kann allerdings auch nach jedem Verdrehen und/oder Verstellen der eine Einheit bildenden Referenzantenne 2 und aktiven Antenne 3, also nach dem Verfahrensschritt $S_7$ ausgeführt werden.

Unter dem Begriff "Einheit", die die aktive Antenne 3 und die Referenzantenne 2 bilden, ist zu verstehen, dass die Referenzantenne 2 während des Messvorgangs des Betrags und der Phase für die Raumwinkel $\vartheta$, $\varphi$ nicht gegenüber der aktiven Antenne 3 verschoben und/oder verdreht werden kann, beide Antennen 2, 3 ortsfest zueinander, also mechanisch fest zueinander angeordnet sind. Der Begriff "Einheit" ist nicht in der Weise aufzufassen, dass beide Antennen auch elektrisch miteinander verbunden sein müssen und miteinander agieren.

Immer wenn von der Erfassung eines Leistungswerts die Rede ist, handelt es sich bevorzugt um die Erfassung eines gemittelten Leistungswerts. Dies bedeutet, dass mehrere, bevorzugt mehr als 100, weiter bevorzugt mehr als 1000 Leistungswerte für eine Messeinstellung, also in einem Verfahrensschritt ST1, ST2 oder ST3 in sehr kurzer Zeit gemessen werden und dass aus diesen Leistungswerten ein gemittelter Leistungswert berechnet wird. Es kann auch sein, dass die aktive Antenne 3 bereits eine gemittelte Leistung ausgibt. In diesem Fall reicht dann genau dieser eine übermittelte Wert. Unter einer Messeinstellung wird verstanden, dass innerhalb einer Messeinstellung der Raumwinkel $\vartheta$, $\varphi$ oder die Amplitude oder die Phase unverändert sind und dass bei den Antennen 2, 6, die das Sendesignal aussenden, keine Änderung ihrer Position oder Ausrichtung erfolgt.

Eine Möglichkeit das Verfahren ebenfalls zu beschreiben gelingt durch:

Verfahren zur Bestimmung von Betrag und Phase aus den Leistungswerten eines durch die aktive Antenne 3 empfangenen Signals, mit den folgenden Verfahrensschritten:

- Verwendung einer Sendeantenne 6 und einer Referenzantenne 2, wobei die Referenzantenne 2 mit vorgegebener Position und vorgegebenem Abstand zur aktiven Antenne 3 angeordnet ist;
- Verwendung eines Signalgenerators 7 zur Erzeugung eines Sendesignals, wobei der Signalgenerator 7 mit der Sendeantenne 6 und der Referenzantenne 2 verbunden ist;

wobei noch die nachfolgenden weiteren Verfahrensschritte in beliebiger Reihenfolge ausgeführt werden:

- Alleiniges Aussenden $S_1$ des Sendesignals durch die Sendeantenne 6 und Erfassen $S_{1\_1}$ eines Leistungswerts des durch die aktive Antenne 3 empfangenen Sendesignals; und/oder
- Alleiniges Aussenden $S_2$ des Sendesignals durch die Referenzantenne 2 und Erfassen $S_{2\_1}$ eines Leistungswerts des durch die aktive Antenne 3 empfangenen Sendesignals; und/oder

- Gleichzeitiges Aussenden $S_3$ des Sendesignals über die Sendeantenne 6 und die Referenzantenne 2 unter Erzeugung von überlagerten Sendesignalen und Erfassen $S_{3\_1}$ eines Leistungswerts der durch die aktive Antenne 3 empfangenen überlagerten Sendesignale;
- Wiederholen $S_{4A}$, $S_{4C}$ der Verfahrensschritte alleiniges Aussenden $S_1$ durch die Sendeantenne 6 und Erfassen $S_{1\_1}$ und/oder alleiniges Aussenden $S_2$ durch die Referenzantenne 2 und Erfassen $S_{2\_1}$ und/oder gleichzeitiges Aussenden $S_3$ und Erfassen $S_{3\_1}$, falls insgesamt noch keine drei Leistungswerte erfasst sind, solange bis insgesamt zumindest drei Leistungswerte erfasst sind, wobei der Verfahrensschritt gleichzeitiges Aussenden $S_3$ und Erfassen $S_{3\_1}$ mindestens einmal ausgeführt wird;

wobei abschließend der nachfolgende Verfahrensschritt ausgeführt wird:

- Berechnen $S_{6A}$, $S_{6B}$, $S_{6C}$ der Phasendifferenz an der aktiven Antenne 3 zwischen dem Sendesignal das von der Sendeantenne 6 ausgesendet wurde und dem Sendesignal das von der Referenzantenne 2 ausgesendet wurde anhand der zumindest drei Leistungswerte, sowie Bestimmung des Betrags des Sendesignals das von der Sendeantenne 6 ausgesendet und von der aktiven Antenne 3 empfangen wurde.

Innerhalb des weiteren Verfahrens und innerhalb der vorherigen Verfahren werden zur Bestimmung der zumindest drei Leistungswerte die Verfahrensschritte alleiniges Aussenden $S_1$ durch die Sendeantenne 6 und Erfassen $S_{1\_1}$ und alleiniges Aussenden $S_2$ durch die Referenzantenne 2 und Erfassen $S_{2\_1}$ bevorzugt maximal einmal ausgeführt. Dies bedeutet, dass auch in den Abfolgen a) oder b) oder c) die Verfahrensschritte ST1 und ST2 bevorzugt nur einmalig ausgeführt werden. Weiter bevorzugt werden diese Verfahrensschritte ST1 und ST2 zweimal oder mehrmals ausgeführt, wenn ein Amplitudensteller 9 ihre Amplitude erhöht oder erniedrigt.
Es ist außerdem grundsätzlich möglich, dass auch mehr als eine Sendeantenne 6 verwendet wird. Es kann auch ein Antennenarray verwendet werden. Bei dem Einsatz von mehreren Sendeantennen 6 sind diese bevorzugt ortsfest zueinander angeordnet. Die mehreren Sendeantennen 6 können gemeinsam oder nacheinander senden. Dabei senden die mehreren Sendeantennen 6 bevorzugt auf unterschiedlichen Frequenzen, wobei die Referenzantenne 2 auf allen diesen Frequenzen bevorzugt gleichzeitig sendet. Die aktive Antenne 3 misst die Leistung auf allen Frequenzen bevorzugt gleichzeitig. Der Verfahrensschritt ST1 kann für eine erste Sendeantenne 6 und für jede weitere Sendeantenne 6 durchgeführt werden. Gleiches gilt auch für den Verfahrensschritt ST3. Auch hier können neben der Referenzantenne 2 noch die mehreren Sendeantennen 6 das Sendesignal gleichzeitig aussenden. Es ist auch möglich, dass die Sendeantenne 6 um die Referenzantenne 2 und die aktive Antenne 3 bevorzugt radial herum bewegt wird. Auch der Einsatz mehrerer Referenzantennen 2 ist prinzipiell möglich.
Die Erfindung ist nicht auf die beschriebenen Ausführungsbeispiele beschränkt. Im Rahmen der Erfindung sind alle beschriebenen und/oder gezeichneten Merkmale beliebig miteinander kombinierbar.

**Patentansprüche**

1. Verfahren zur Bestimmung von Leistungswerten eines durch die aktive Antenne (3) empfangenen Signals um damit den Betrag und die Phase bestimmen zu können, mit den folgenden Verfahrensschritten:

   - Verwendung zumindest einer Sendeantenne (6) und einer Referenzantenne (2), wobei die Referenzantenne (2) mit vorgegebener Position und vorgegebenem Abstand zur aktiven Antenne (3) angeordnet ist;
   - Verwendung eines Signalgenerators (7) zur Erzeugung eines Sendesignals, wobei der Signalgenerator (7) mit der zumindest einen Sendeantenne (6) und der Referenzantenne (2) verbunden ist;

   wobei aus der Gruppe der nachfolgenden Verfahrensschritte (ST1, ST2, ST3):

   ST1: Alleiniges Aussenden ($S_1$) des Sendesignals durch die zumindest eine Sendeantenne (6) und Erfassen ($S_{1\_1}$) eines Leistungswerts des durch die aktive Antenne (3) empfangenen Sendesignals;
   ST2: Alleiniges Aussenden ($S_2$) des Sendesignals durch die Referenzantenne (2) und Erfassen ($S_{2\_1}$) eines Leistungswerts des durch die aktive Antenne (3) empfangenen Sendesignals;
   ST3: Gleichzeitiges Aussenden ($S_3$) des Sendesignals über die zumindest eine Sendeantenne (6) und die Referenzantenne (2) unter Erzeugung von überlagerten Sendesignalen und Erfassen ($S_{3\_1}$) eines Leistungswerts der durch die aktive Antenne (3) empfangenen überlagerten Sendesignale;

   eine Abfolge von zumindest drei Verfahrensschritten (ST1, ST2, ST3) in beliebiger Reihenfolge und mit beliebiger Kombination, auch unter mehrfacher Durchführung zumindest eines Verfahrensschritts (ST1, ST2, ST3) durchgeführt wird, wobei die Abfolge der zumindest drei Verfahrensschritte (ST1, ST2, ST3) stets zumindest einmal den Verfahrensschritt ST3 umfasst.

2. Verfahren nach Anspruch 1, **dadurch gekennzeichnet, dass** zur Erfassung der zumindest drei Leistungswerte und damit zur Bestimmung von Betrag und Phase zumindest eine der folgenden drei Abfolgen a) oder b) oder c) bei gleicher Ausrichtung und Position der aktiven Antenne (3) und Referenzantenne (2) in Relation zu der zumindest einen Sendeantenne (6) durchgeführt wird:

   a):

   • Durchführen von Verfahrensschritt ST1 oder ST2;
   • Durchführen von Verfahrensschritt ST3;
   • Wiederholen ($S_{4A}$) des Verfahrensschritts ST3 bis insgesamt zumindest drei Leistungswerte erfasst sind;

   oder
   b):

   • Durchführen von Verfahrensschritt ST1;
   • Durchführen von Verfahrensschritt ST2;
   • Durchführen von Verfahrensschritt ST3;

   oder
   c):

   • Durchführen von Verfahrensschritt ST3;
   • Wiederholen ($S_{4C}$) des Verfahrensschrittes ST3 bis insgesamt zumindest drei Leistungswerte erfasst sind.

3. Verfahren nach Anspruch 2, **dadurch gekennzeichnet, dass** die Abfolgen a) oder b) oder c) durch die folgenden Verfahrensschritte näher beschrieben werden:

   a):

   - Verwendung eines Phasenstellers (10) und/oder eines Amplitudenstellers (9), der zwischen dem Signalgenerator (7) und der zumindest einen Sendeantenne (6) und/oder zwischen dem Signalgenerator (7) und der Referenzantenne (2) geschalten ist;
   - Durchführen des Verfahrensschritts ST1 oder ST2;
   - Durchführen des Verfahrensschritts ST3;
   - Durchführen einer Phasenveränderung ($S_{5A}$) zwischen dem Sendesignal an der zumindest einen Sendeantenne (6) und dem Sendesignal an der Referenzantenne (2) und/oder Durchführen einer Amplitudenveränderung des Sendesignals an der zumindest einen Sendeantenne (6) und/oder des Sendesignals an der Referenzantenne (2);
   - Wiederholen ($S_{4A}$) des Verfahrensschritts ST3 und des Verfahrensschritts Phasenveränderung ($S_{5A}$) und/oder Amplitudenveränderung bis für zumindest zwei unterschiedliche Phasenwerte zwischen dem Sendesignal an der zumindest einen Sendeantenne (6) und dem Sendesignal an der Referenzantenne (2) und/oder bis für zumindest zwei unterschiedliche Amplitudenwerte des Sendesignals an der zumindest einen Sendeantenne (6) und/oder des Sendesignals an der Referenzantenne (2) zumindest je ein Leistungswert erfasst ist;
   - Berechnen ($S_{6A}$) der Phasendifferenz an der aktiven Antenne (3) zwischen dem Sendesignal das von der zumindest einen Sendeantenne (6) ausgesendet wurde und dem Sendesignal das von der Referenzantenne (2) ausgesendet wurde anhand der zumindest drei Leistungswerte, sowie Bestimmung des Betrags des Sendesignals das von der zumindest einen Sendeantenne (6) ausgesendet und von der aktiven Antenne (3) empfangen wurde durch:

      i) das Messergebnis, also den Leistungswert aus dem Verfahrensschritt ST1 falls dieser durchgeführt worden ist und die zumindest eine Sendeantenne (6) das Sendesignal alleine ausgesendet hat; oder
      ii) die zumindest drei Leistungswerte, wenn der Verfahrensschritt ST2 durchgeführt worden ist und die Referenzantenne (2) das Sendesignal alleine ausgesendet hat;

oder

b) :

- Durchführen des Verfahrensschritts ST1;
- Durchführen des Verfahrensschritts ST2;
- Durchführen des Verfahrensschritts ST3;
- Berechnen ($S_{6B}$) der Phasendifferenz an der aktiven Antenne (3) zwischen dem Sendesignal das von der zumindest einen Sendeantenne (6) ausgesendet wurde und dem Sendesignal das von der Referenzantenne (2) ausgesendet wurde anhand der zumindest drei Leistungswerte und Bestimmen des Betrags des Sendesignals, das von der zumindest einen Sendeantenne (6) ausgesendet und von der aktiven Antenne (3) empfangen wurde mit dem Leistungswert aus dem Verfahrensschritt ST1 als einzig die zumindest eine Sendeantenne (6) das Sendesignal ausgesendet hat,

oder

c) :

- Verwendung eines Phasenstellers (10) und/oder eines Amplitudenstellers (9), der zwischen dem Signalgenerator (7) und der zumindest einen Sendeantenne (6) und/oder zwischen dem Signalgenerator (7) und der Referenzantenne (2) geschalten ist und/oder Durchführen einer Amplitudenveränderung des Sendesignals an der zumindest einen Sendeantenne (6) und/oder des Sendesignals an der Referenzantenne (2);;
- Durchführen des Verfahrensschritts ST3;
- Durchführen einer Phasenveränderung ($S_{5C}$) zwischen dem Sendesignal an der zumindest einen Sendeantenne (6) und dem Sendesignal an der Referenzantenne (2) und/oder Durchführen einer Amplitudenveränderung des Sendesignals an der zumindest einen Sendeantenne (6) und/oder des Sendesignals an der Referenzantenne (2);
- Wiederholen ($S_{4C}$) des Verfahrensschritts ST3 und des Verfahrensschritts Phasenveränderung ($S_{5C}$) und/oder Amplitudenveränderung bis für zumindest drei unterschiedliche Phasenwerte zwischen dem Sendesignal an der zumindest einen Sendeantenne (6) und dem Sendesignal an der Referenzantenne (2) und/oder bis für zumindest drei unterschiedliche Amplitudenwerte des Sendesignals an der zumindest einen Sendeantenne (6) und/oder des Sendesignals an der Referenzantenne (2) zumindest je ein Leistungswert erfasst ist;
- Berechnen ($S_{6C}$) der Phasendifferenz an der aktiven Antenne (3) zwischen dem Sendesignal das von der zumindest einen Sendeantenne (6) ausgesendet wurde und dem Sendesignal das von der Referenzantenne (2) ausgesendet wurde, sowie Berechnung des Betrags des Sendesignals, das von der zumindest einen Sendeantenne (6) ausgesendet und von der aktiven Antenne (3) empfangen wird anhand der zumindest drei Leistungswerte.

4. Verfahren nach Anspruch 3, **dadurch gekennzeichnet, dass** in dem Verfahrensschritt Wiederholen ($S_{4A}$, $S_{4C}$) der Verfahrensschritt ST3 und der Verfahrensschritt Phasenveränderung ($S_{5A}$, $S_{5C}$) und/oder Amplitudenveränderung derart oft nacheinander ausgeführt werden, bis für zumindest drei oder zumindest vier unterschiedliche Phasenwerte zwischen dem Sendesignal an der zumindest einen Sendeantenne (6) und dem Sendesignal an der Referenzantenne (2) und/oder bis für zumindest drei oder zumindest vier unterschiedliche Amplitudenwerte des Sendesignals an der zumindest einen Sendeantenne (6) und/oder des Sendesignals an der Referenzantenne (2) zumindest je ein Leistungswert erfasst ist.

5. Verfahren nach Anspruch 3 oder 4, **dadurch gekennzeichnet, dass** beim mehrmaligen Durchführen des Verfahrensschritts Phasenveränderung ($S_{5A}$, $S_{5C}$) nacheinander vier Phasenveränderungen zwischen dem Sendesignal der zumindest einen Sendeantenne (6) und dem Sendesignal an der Referenzantenne (2) von 0°, $\Delta$°, 2·$\Delta$° und 3 · $\Delta$° aufgeschalten werden, wobei $\Delta$° im Bereich zwischen 80° und 100° liegt, bevorzugt 90° entspricht.

6. Verfahren nach einem der Ansprüche 3 bis 5, **dadurch gekennzeichnet, dass** die einzelnen Phasenwerte, die der Phasensteller (10) für einen Raumwinkel ($\vartheta$, $\varphi$) nacheinander einstellt um $\alpha$° voneinander beabstandet sind, wobei

$$\alpha° = \frac{360°}{Anzahl\ Phasenwerte}\ \text{ist.}$$

7. Verfahren nach einem der vorherigen Ansprüche, **gekennzeichnet durch** die folgenden weiteren Verfahrensschritte:

- Gemeinsames Verdrehen und/oder Verstellen ($S_7$) der vorzugsweise aus einer Einheit bestehenden aktiven Antenne (3) und Referenzantenne (2) relativ gegenüber der zumindest einen Sendeantenne (6), so dass unterschiedliche Empfangsrichtungen gemessen werden können;
- Durchführen ($S_8$) der Verfahrensschritte ST1 und/oder ST2 und/oder ST3 oder Durchführen der Abfolgen a) oder b) oder c).

8.  Verfahren nach Anspruch 7, **dadurch gekennzeichnet, dass** innerhalb des Verfahrensschritts Verdrehen und/oder Verstellen ($S_7$) vorzugsweise die Einheit aus aktiver Antenne (3) und Referenzantenne (2) bezüglich ihres Azimutwinkels (cp) und/oder ihres Elevationswinkels ($\vartheta$) gemeinsam gegenüber der zumindest einen Sendeantenne (6) verdreht und/oder verstellt wird.

9.  Verfahren nach Anspruch 7 oder 8, **gekennzeichnet durch** die folgenden weiteren Verfahrensschritte:

    - Erneutes Ausführen ($S_9$) der Schritte Verdrehen ($S_7$) und Durchführen ($S_8$), solange bis die Beträge und die Phasen für die aktive Antenne für die gewünschten Raumwinkel ($\vartheta$, $\varphi$) oder für alle Raumwinkel ($\vartheta$, $\varphi$) ermittelt sind.

10. Verfahren nach einem der vorherigen Ansprüche, **gekennzeichnet durch** die folgenden weiteren Verfahrensschritte:

    - Verwendung eines Amplitudenstellers (9), der zwischen dem Signalgenerator (7) und der zumindest einen Sendeantenne (6) und/ oder zwischen dem Signalgenerator (7) und der Referenzantenne (2) geschalten ist;
    - Einstellen ($S_{10}$) der Amplitude des Sendesignals an der zumindest einen Sendeantenne (6) und/oder des Sendesignals an der Referenzantenne (2) derart, dass die Höhe der Leistung eines Sendesignals weniger als 20-mal, bevorzugt weniger als zehnmal, weiter bevorzugt weniger als fünfmal, weiter bevorzugt weniger als zweimal so hoch ist, wie die Leistung des anderen Sendesignals am Ort der aktiven Antenne (3).

11. Verfahren nach einem der vorherigen Ansprüche, **gekennzeichnet durch** die folgenden weiteren Verfahrensschritte:

    - Anordnen der Referenzantenne (2) an der aktiven Antenne (3), derart, dass der Abstand zwischen der Referenzantenne (2) und der aktiven Antenne (3) weniger als 100 cm, bevorzugt weniger als 50 cm, weiter bevorzugt weniger als 25 cm, weiter bevorzugt weniger als 10 cm beträgt.

12. Verfahren nach einem der vorherigen Ansprüche, **dadurch gekennzeichnet, dass** die zumindest eine Sendeantenne (6) und/oder die Referenzantenne (2) ein moduliertes oder unmoduliertes Sendesignal aussenden.

13. Messeinrichtung (1) zur Bestimmung von Leistungswerten eines durch eine aktive Antenne (3) empfangenen Signals zur Berechnung von Betrag und Phase, mit den folgenden Merkmalen:

    - zumindest einer Sendeantenne (6) und einer Referenzantenne (2), wobei die Referenzantenne (2) mit vorgegebener Position und vorgegebenem Abstand zur aktiven Antenne (3) angeordnet ist;
    - einem Signalgenerator (7) zur Erzeugung eines Sendesignals, wobei der Signalgenerator (7) mit der zumindest einen Sendeantenne (6) und der Referenzantenne (2) verbunden ist;
    - einer Steuereinheit (11), die bei gleicher Ausrichtung und Position der aktiven Antenne (3) und Referenzantenne (2) in Relation zu der zumindest einen Sendeantenne (6) derart ausgebildet und mit der aktiven Antenne (3) und dem Signalgenerator (7) verbunden ist, dass die nachfolgenden Verfahrensschritte ausführbar sind:

        ST1: Alleiniges Aussenden ($S_1$) des Sendesignals durch die zumindest eine Sendeantenne (6) und Erfassen ($S_{1\_1}$) eines Leistungswerts des durch die aktive Antenne (3) empfangenen Sendesignals;
        ST2: Alleiniges Aussenden ($S_2$) des Sendesignals durch die Referenzantenne (2) und Erfassen ($S_{2\_1}$) eines Leistungswerts des durch die aktive Antenne (3) empfangenen Sendesignals;
        ST3: Gleichzeitiges Aussenden ($S_3$) des Sendesignals über die zumindest eine Sendeantenne (6) und die Referenzantenne (2) unter Erzeugung von überlagerten Sendesignalen und Erfassen ($S_{3\_1}$) eines Leistungswerts der durch die aktive Antenne (3) empfangenen überlagerten Sendesignale;

    wobei die Steuereinheit (11) weiterhin dazu ausgebildet ist, dass eine Abfolge von zumindest drei Verfahrensschritten (ST1, ST2, ST3) in beliebiger Reihenfolge und mit beliebiger Kombination, auch unter mehrfaeher Durchführung zumindest eines Verfahrensschritts (ST1, ST2, ST3) durchgeführt wird, wobei die Abfolge der zumindest drei Verfahrensschritte (ST1, ST2, ST3) stets zumindest einmal den Verfahrensschritt ST3 umfasst.

14. Messeinrichtung nach Anspruch 13, **dadurch gekennzeichnet, dass** die Steuereinheit (11) weiterhin derart ausgebildet ist:

- dass zur Erfassung der zumindest drei Leistungswerte und damit zur Bestimmung von Betrag und Phase zumindest eine der folgenden drei Abfolgen a) oder b) oder c) bei gleicher Ausrichtung und Position der aktiven Antenne (3) und Referenzantenne (2) in Relation zu der zumindest einen Sendeantenne (6) durchgeführt wird:

a) :

- Durchführen von Verfahrensschritt ST1 oder ST2;
- Durchführen von Verfahrensschritt ST3;
- Wiederholen ($S_{4A}$) des Verfahrensschritts ST3 bis insgesamt zumindest drei Leistungswerte erfasst sind;

oder:
b)

- Durchführen von Verfahrensschritt ST1;
- Durchführen von Verfahrensschritt ST2;
- Durchführen von Verfahrensschritt ST3;

oder:
c)

- Durchführen von Verfahrensschritt ST3;
- Wiederholen ($S_{4C}$) des Verfahrensschritts ST3 bis insgesamt zumindest drei Leistungswerte erfasst sind.

15. Messeinrichtung nach Anspruch 14, **dadurch gekennzeichnet, dass** die Abfolgen a) oder b) oder c) durch die folgenden Merkmale näher beschrieben werden:

a) :

- dass die Messeinrichtung (1) einen Phasensteller (10) und/oder Amplitudensteller (9) aufweist, der zwischen dem Signalgenerator (7) und der zumindest einen Sendeantenne (6) und/oder zwischen dem Signalgenerator (7) und der Referenzantenne (2) geschalten ist und der durch die Steuereinheit steuerbar ist;
- dass die Steuereinheit (11) dazu ausgebildet ist, die nachfolgenden Verfahrensschritte auszuführen:

- Durchführen des Verfahrensschritts ST1 oder ST2;
- Durchführen des Verfahrensschritts ST3;
- Durchführen einer Phasenveränderung ($S_{5A}$) zwischen dem Sendesignal an der zumindest einen Sendeantenne (6) und dem Sendesignal an der Referenzantenne (2) und/oder Durchführen einer Amplitudenveränderung des Sendesignals an der zumindest einen Sendeantenne (6) und/oder des Sendesignals an der Referenzantenne (2);
- Wiederholen ($S_{4A}$) des Verfahrensschritts ST3 und des Verfahrensschritts Phasenveränderung ($S_{5A}$) und/oder Amplitudenveränderung bis für zumindest zwei unterschiedliche Phasenwerte zwischen dem Sendesignal an der zumindest einen Sendeantenne (6) und dem Sendesignal an der Referenzantenne (2) und/oder für zumindest zwei unterschiedliche Amplitudenwerte des Sendesignals an der zumindest einen Sendeantenne (6) und/oder des Sendesignals an der Referenzantenne (2) zumindest je ein Leistungswert erfasst ist;
- Berechnen ($S_{6A}$) der Phasendifferenz an der aktiven Antenne (3) zwischen dem Sendesignal das von der zumindest einen Sendeantenne (6) ausgesendet wurde und dem Sendesignal das von der Referenzantenne (2) ausgesendet wurde anhand der zumindest drei Leistungswerte, sowie Bestimmung des Betrags des Sendesignals das von der zumindest einen Sendeantenne (6) ausgesendet und von der aktiven Antenne (3) empfangen wurde:

i) durch das Messergebnis, also den Leistungswert aus dem Verfahrensschritt ST1 falls dieser durchgeführt worden ist und die zumindest eine Sendeantenne (6) das Sendesignal alleine ausgesendet hat; oder

ii) durch die zumindest drei Leistungswerte, wenn der Verfahrensschritt ST2 durchgeführt worden ist und die Referenzantenne (2) das Sendesignal alleine ausgesendet hat;

oder

b) :

- dass die Steuereinheit (11) dazu ausgebildet ist, die nachfolgenden Verfahrensschritte auszuführen:

• Durchführen des Verfahrensschritts ST1;
• Durchführen des Verfahrensschritts ST2;
• Durchführen des Verfahrensschritts ST3;
• Berechnen ($S_{6B}$) der Phasendifferenz an der aktiven Antenne (3) zwischen dem Sendesignal das von der zumindest einen Sendeantenne (6) ausgesendet wurde und dem Sendesignal das von der Referenzantenne (2) ausgesendet wurde anhand der zumindest drei Leistungswerte und Bestimmen des Betrags des Sendesignals, das von der zumindest einen Sendeantenne (6) ausgesendet und von der aktiven Antenne (3) empfangen wurde mit dem Leistungswert aus dem Verfahrensschritt ST1 als einzig die zumindest eine Sendeantenne (6) das Sendesignal ausgesendet hat;

oder

c) :

- dass die Messeinrichtung (1) einen Phasensteller (10) und/oder Amplitudensteller (9) aufweist, der zwischen dem Signalgenerator (7) und der zumindest einen Sendeantenne (6) und/oder zwischen dem Signalgenerator (7) und der Referenzantenne (2) geschalten ist und der durch die Steuereinheit steuerbar ist;
- dass die Steuereinheit (11) dazu ausgebildet ist, die nachfolgenden Verfahrensschritte auszuführen:

• Durchführen des Verfahrensschritts ST3;
• Durchführen einer Phasenveränderung ($S_{5C}$) zwischen dem Sendesignal an der zumindest einen Sendeantenne (6) und dem Sendesignal an der Referenzantenne (2) und/oder Durchführen einer Amplitudenveränderung des Sendesignals an der zumindest einen Sendeantenne (6) und/oder des Sendesignals an der Referenzantenne (2);
• Wiederholen ($S_{4C}$) des Verfahrensschritts ST3 und des Verfahrensschritts Phasenveränderung ($S_{5C}$) und/oder Amplitudenveränderung bis für zumindest drei unterschiedliche Phasenwerte zwischen dem Sendesignal an der zumindest einen Sendeantenne (6) und dem Sendesignal an der Referenzantenne (2) und/oder bis für zumindest drei unterschiedliche Amplitudenwerte des Sendesignals an der zumindest Sendeantenne (6) und/oder des Sendesignals an der Referenzantenne (2) zumindest je ein Leistungswert erfasst ist;
• Berechnen ($S_{6C}$) der Phasendifferenz an der aktiven Antenne (3) zwischen dem Sendesignal das von der zumindest einen Sendeantenne (6) ausgesendet wurde und dem Sendesignal das von der Referenzantenne (2) ausgesendet wurde, sowie Berechnung des Betrags des Sendesignals, das von der zumindest einen Sendeantenne (6) ausgesendet und von der aktiven Antenne (3) empfangen wurde anhand der zumindest drei Leistungswerte.

16. Messeinrichtung nach Anspruch 15, **dadurch gekennzeichnet, dass** der Phasensteller (10) derart ausgebildet ist und von der Steuereinheit (11) ansteuerbar ist, dass die Leistungswerte für zumindest drei oder zumindest vier unterschiedliche Phasenwerte zwischen dem Sendesignal an der zumindest einen Sendeantenne (6) und dem Sendesignal an der Referenzantenne (2) und/oder bis für zumindest drei oder zumindest vier unterschiedliche Amplitudenwerte des Sendesignals an der zumindest einen Sendeantenne (6) und/oder des Sendesignals an der Referenzantenne (2) erfassbar ist.

17. Messeinrichtung gemäß Anspruch 15 oder 16, **dadurch gekennzeichnet, dass** die Steuereinheit (11) derart ausgebildet ist, um den Phasensteller (10) derart anzusteuern, dass durch diesen nacheinander vier Phasenveränderungen zwischen dem Sendesignal der zumindest einen Sendeantenne (6) und dem Sendesignal an der Referenzantenne (2) von 0°, $\Delta°$, $2\cdot\Delta°$ und $3\cdot\Delta°$ einstellbar sind, wobei $\Delta°$ im Bereich zwischen 80° und 100° liegt, bevorzugt 90° entspricht.

**18.** Messeinrichtung gemäß einem der der Ansprüche 15 bis 17, **dadurch gekennzeichnet, dass** die einzelnen Phasenwerte, die der Phasensteller (10) für einen Raumwinkel ($\vartheta$, $\varphi$) einstellt um $\alpha°$ voneinander beabstandet sind,

wobei $\alpha° = \dfrac{360°}{Anzahl\ Phasenwerte}$ ist.

**19.** Messeinrichtung gemäß einem der Ansprüche 13 bis 18, **dadurch gekennzeichnet, dass** die Steuereinheit (11) derart ausgebildet ist, dass die vorzugsweise aus einer Einheit bestehende aktive Antenne (3) und Referenzantenne (2) relativ gegenüber der zumindest einen Sendeantenne (6) gemeinsam verdrehbar und/oder verstellbar sind, so dass unterschiedliche Empfangsrichtungen, also Raumwinkel ($\vartheta$, $\varphi$) gemessen werden können.

**20.** Messeinrichtung gemäß Anspruch 19, **dadurch gekennzeichnet, dass** vorzugsweise die Einheit aus aktiver Antenne (3) und Referenzantenne (2) bezüglich ihres Azimutwinkels (cp) und/oder ihres Elevationswinkels ($\vartheta$) gemeinsam gegenüber der zumindest einen Sendeantenne (6) verdrehbar und/oder verstellbar ist.

**21.** Messeinrichtung gemäß einem der Ansprüche 13 bis 20, **dadurch gekennzeichnet, dass** die Messeinrichtung (1) einen Amplitudensteller (9) aufweist, der zwischen dem Signalgenerator (7) und der zumindest einen Sendeantenne (6) und/oder zwischen dem Signalgenerator (7) und der Referenzantenne (2) geschalten ist und dass die Steuereinheit (11) derart ausgebildet ist, um den Amplitudensteller (9) derart anzusteuern, dass die Amplitude des Sendesignals an der zumindest einen Sendeantenne (6) und/oder des Sendesignals an der Referenzantenne (2) derart einstellbar ist, dass die Höhe der Leistung eines Sendesignals am Ort der aktiven Antenne (3) weniger als 20-mal, bevorzugt weniger als zehnmal, weiter bevorzugt weniger als fünfmal, weiter bevorzugt weniger als zweimal so hoch ist, wie die Leistung des anderen Sendesignals.

**22.** Messeinrichtung gemäß einem der Ansprüche 13 bis 21, **dadurch gekennzeichnet, dass** der Abstand zwischen der Referenzantenne (2) und der aktiven Antenne (3) weniger als 100 cm, bevorzugt weniger als 50 cm, weiter bevorzugt weniger als 25 cm, weiter bevorzugt weniger als 10 cm beträgt.

**23.** Messeinrichtung gemäß einem der Ansprüche 13 bis 22, **dadurch gekennzeichnet, dass** zusätzlich ein Schnittstellengerät (12) zwischen der Steuereinheit (11) und der aktiven Antenne (3) geschaltet ist.

**24.** Messeinrichtung gemäß einem der Ansprüche 13 bis 23, **dadurch gekennzeichnet, dass** die zumindest eine Sendeantenne (6) und/oder die Referenzantenne (2) ein moduliertes oder unmoduliertes Sendesignal aussenden.

## Claims

**1.** A method for determining the power values of a signal received by the active antenna (3) in order thus to be able to determine the magnitude and the phase, comprising the following method steps:

- use of at least one transmitting antenna (6) and a reference antenna (2), wherein the reference antenna (2) is disposed at a predetermined position and a predetermined spacing relative to the active antenna (3) ;
- use of a signal generator (7) for production of a transmission signal, wherein the signal generator (7) is connected to the at least one transmitting antenna (6) and to the reference antenna (2);

wherein from the group of the following method steps (ST1, ST2, ST3):

ST1: only transmission ($S_1$) of the transmission signal by the at least one transmitting antenna (6) and capture ($S_{1\_1}$) of a power value of the transmission signal received by the active antenna (3);
ST2: only transmission ($S_2$) of the transmission signal by the reference antenna (2) and capture ($S_{2\_1}$) of a power value of the transmission signal received by the active antenna (3);
ST3: simultaneous transmission ($S_3$) of the transmission signal by means of the at least one transmitting antenna (6) and the reference antenna (2) while generating superimposed transmission signals and capture ($S_{3\_1}$) of a power value of the superimposed transmission signals received by the active antenna (3) ;

a sequence of at least three method steps (ST1, ST2, ST3) is carried out in any order and in any combination, with at least one method step (ST1, ST2, ST3) being carried out multiple times, wherein the sequence of the at least three method steps (ST1, ST2, ST3) always comprises the method step ST3 at least once.

**2.** The method according to claim 1, **characterized in that,** for capture of the at least three power values and thus for determining the magnitude and phase, at least one of the following three sequences a) or b) or c) with the same orientation and position of the active antenna (3) and reference antenna (2) in relation to the at least one transmitting antenna (6) is carried out:

a) :

- carrying out of method step ST1 or ST2;
- carrying out of method step ST3;
- repeating ($S_{4A}$) the method step ST3 until overall at least three power values are captured;

or
b) :

- carrying out of method step ST1;
- carrying out of method step ST2;
- carrying out of method step ST3;

or
c) :

- carrying out of method step ST3;
- repeating ($S_{4C}$) the method step ST3 until overall at least three power values are captured.

**3.** The method according to claim 2, **characterized in that** the sequences a) or b) or c) are described in greater detail by the following method steps:

a) :

- Use of a phase controller (10) and/or an amplitude controller (9) which is connected between the signal generator (7) and the at least one transmitting antenna (6) and/or between the signal generator (7) and the reference antenna (2);
- carrying out of method step ST1 or ST2;
- carrying out of method step ST3;
- carrying out of a phase change ($S_{5A}$) between the transmission signal on the at least one transmitting antenna (6) and the transmission signal on the reference antenna (2) and/or carrying out of an amplitude change of the transmission signal on the at least one transmitting antenna (6) and/or of the transmission signal on the reference antenna (2):
- repeating ($S_{4A}$) the previous method step ST3 and of the method step of phase change ($S_{5A}$) and/or amplitude change are carried out until at least one power value in each case is captured for at least two different phase values between the transmission signal on the at least one transmitting antenna (6) and the transmission signal on the reference antenna (2) and/or for at least two different amplitude values of the transmission signal on the at least one transmitting antenna (6) and/or of the transmission signal on the reference antenna (2);
- calculation ($S_{6A}$) of the phase difference on the active antenna (3) between the transmission signal which was transmitted by the at least one transmitting antenna (6) and the transmission signal which was transmitted by the reference antenna (2) with reference to the at least three power values, as well as determination of the magnitude of the transmission signal which was transmitted by the at least one transmitting antenna (6) and received by the active antenna (3), by:

  i) the measured result, that is to say the power value from the method step ST1 if this has been carried out and the at least one transmitting antenna (6) alone has transmitted the transmission signal; or
  ii) the at least three power values, if the method step ST2 has been carried out and the reference antenna (2) alone has transmitted the transmission signal;

or
b) :

- carrying out of method step ST1;
- carrying out of method step ST2;
- carrying out of method step ST3;
- calculation ($S_{6B}$) of the phase difference on the active antenna (3) between the transmission signal which was transmitted by the at least one transmitting antenna (6) and the transmission signal which was transmitted by the reference antenna (2) with reference to the at least three power values, and determination of the magnitude of the transmission signal which was transmitted by the at least one transmitting antenna (6) and received by the active antenna (3) with the power value from the method step ST1 as only the at least one transmitting antenna (6) has transmitted the transmission signal,

or

c) :

- use of a phase controller (10) and/or an amplitude controller (9) which is connected between the signal generator (7) and the at least one transmitting antenna (6) and/or between the signal generator (7) and the reference antenna (2); and/or carrying out of an amplitude change of the transmission signal on the at least one transmitting antenna (6) and/or of the transmission signal on the reference antenna (2);
- carrying out of method step ST3;
- carrying out of a phase change ($S_{5C}$) between the transmission signal on the at least one transmitting antenna (6) and the transmission signal on the reference antenna (2) and/or carrying out of an amplitude change of the transmission signal on the at least one transmitting antenna (6) and/or of the transmission signal on the reference antenna (2):
- repeating ($S_{4C}$) the previous method step ST3 and of the method step of phase change ($S_{5C}$) and/or amplitude change are carried out until at least one power value in each case is captured for at least three different phase values between the transmission signal on the at least one transmitting antenna (6) and the transmission signal on the reference antenna (2) and/or for at least three different amplitude values of the transmission signal on the at least one transmitting antenna (6) and/or of the transmission signal on the reference antenna (2);
- calculation ($S_{6C}$) of the phase difference on the active antenna (3) between the transmission signal which was transmitted by the at least one transmitting antenna (6) and the transmission signal which was transmitted by the reference antenna (2), as well as calculation of the magnitude of the transmission signal which is transmitted by the at least one transmitting antenna (6) and received by the active antenna (3), with reference to the at least three power values.

4.  The method according to claim 3, **characterized in that** in the method step of repetition ($S_{4A}$, $S_{4C}$) of the previous method step ST3 and the method step of phase change ($S_{5A}$, $S_{5C}$) and/or amplitude change are carried out successively as often as required until at least one power value in each case is captured for at least three or at least four different phase values between the transmission signal on the at least one transmitting antenna (6) and the transmission signal on the reference antenna (2) and/or for at least three or at least four different amplitude values of the transmission signal on the at least one transmitting antenna (6) and/or of the transmission signal on the reference antenna (2).

5.  The method according to claim 3 or 4, **characterized in that** when the method step of phase change ($S_{5A}$, $S_{5C}$) is carried out multiple times four successive phase changes of $0°$, $\Delta°$, $2 \cdot \Delta°$ and $3 \cdot \Delta°$, wherein $\Delta°$ is in the range between $80°$ and $100°$ and preferably corresponds to $90°$, are applied between the transmission signal of the at least one transmitting antenna and the transmission signal on the reference antenna.

6.  The method according to one of claims 3 to 5, **characterized in that** the individual phase values which the phase controller (10) sets for a solid angle ($\vartheta$, $\varphi$) one after the other are spaced apart from one another by $\alpha°$, wherein

$$\alpha° = \frac{360°}{number\ of\ phase\ values} \ .$$

7.  The method according to one of the preceding claims, **characterized by** the following further method steps:

- rotation and/or adjustment ($S_7$) of the active antenna (3) and reference antenna (2), preferably consisting of one unit, relative to the at least one transmitting antenna (6), so that different reception directions can be measured;

- carrying out ($S_8$) of the method steps ST1 and/or ST2 and/or ST3 or carrying out of the sequences a) or b) or c) .

8.  The method according to claim 7, **characterized in that** within the method step of rotation and/or adjustment ($S_7$) the unit comprising the active antenna (3) and the reference antenna (2) is preferably rotated and/or adjusted jointly with respect to its azimuth angle ($\varphi$) and/or its angle of elevation ($\vartheta$) relative to the at least one transmitting antenna (6).

9.  The method according to claim 7 or 8, **characterized by** the following further method steps:

    - repeating the steps ($S_9$) of rotation ($S_7$) and carrying out ($S_8$) as often as required until the magnitudes and the phases for the required solid angles ($\vartheta$, $\varphi$) or for all solid angles ($\vartheta$, $\varphi$) are determined.

10. The method according to one of the preceding claims, **characterized by** the following further method steps:

    - use of an amplitude controller (9) which is connected between the signal generator (7) and the at least one transmitting antenna (6) and/or between the signal generator (7) and the reference antenna (2);
    - setting ($S_{10}$) of the amplitude of the transmission signal on the at least one transmitting antenna (6) and/or of the transmission signal on the reference antenna (2) in such a way that the power level of a transmission signal is less than 20 times as high, preferably less than ten times as high, or more preferably less than five times as high, or more preferably less than twice as high, as the power of the other transmission signal at the location of the active antenna (3).

11. The method according to one of the preceding claims, **characterized by** the following further method steps:

    - arranging the reference antenna (2) on the active antenna (3) in such a way that the spacing between the reference antenna (2) and the active antenna (3) is less than 100 cm, preferably less than 50 cm, more preferably less than 25 cm and more preferably less than 10 cm.

12. Method according to one of the preceding claims, **characterized in that** the at least one transmitting antenna (6) and/or the reference antenna (2) transmit a modulated or unmodulated transmission signal.

13. A measuring device (1) for determining the power values of a signal received by an active antenna (3) for calculation of the magnitude and phase, comprising the following features:

    - at least one transmitting antenna (6) and a reference antenna (2), wherein the reference antenna (2) is disposed at a predetermined position and a predetermined spacing relative to the active antenna (3) ;
    - a signal generator (7) for production of a transmission signal, wherein the signal generator (7) is connected to the at least one transmitting antenna (6) and to the reference antenna (2);
    - a control unit (11) which, with the same orientation and position of the active antenna (3) and the reference antenna (2) in relation to the at least one transmitting antenna (6), is designed and connected to the active antenna (3) and the signal generator (7) in such a way that the following method steps can be carried out:

      ST1: only transmission ($S_1$) of the transmission signal by the at least one transmitting antenna (6) and capture ($S_{1\_1}$) of a power value of the transmission signal received by the active antenna (3);
      ST2: only transmission ($S_2$) of the transmission signal by the reference antenna (2) and capture ($S_{2\_1}$) of a power value of the transmission signal received by the active antenna (3);
      ST3: simultaneous transmission ($S_3$) of the transmission signal by means of the at least one transmitting antenna (6) and the reference antenna (2) while generating superimposed transmission signals and capture ($S_{3\_1}$) of a power value of the superimposed transmission signals received by the active antenna (3);

    wherein the control unit (11) is designed so that a sequence of at least three method steps (ST1, ST2, ST3) is carried out in any order and in any combination, also with at least one method step (ST1, ST2, ST3) being carried out multiple times, wherein the sequence of the at least three method steps (ST1, ST2, ST3) always comprises the method step ST3 at least once.

14. The measuring device according to claim 13, **characterized in that** the control unit (11) is also designed in such a way that:

    - for capture of the at least three power values and thus for determination of the magnitude and phase, at least one of the following three sequences a) or b) or c) with the same orientation and position of the active antenna (3) and reference antenna (2) in relation to the at least one transmitting antenna (6) is carried out:

a) :

- carrying out of method step ST1 or ST2;
- carrying out of method step ST3;
- repeating ($S_{4A}$) the method step ST3 until overall at least three power values are captured;

or:
b)

- carrying out of method step ST1;
- carrying out of method step ST2;
- carrying out of method step ST3;

or:
c)

- carrying out of method step ST3;
- repeating ($S_{4C}$) the method step ST3 until overall at least three power values are captured.

**15.** The measuring device according to claim 14, **characterized in that** the sequences a) or b) or c) are described in greater detail by the following features:

a) :

- that the measuring device (1) has a phase controller (10) and/or an amplitude controller (9) which is connected between the signal generator (7) and the at least one transmitting antenna (6) and/or between the signal generator (7) and the reference antenna (2) and is controllable by the control unit;
- that the control unit (11) is designed to carry out the following method steps:

  - carrying out of method step ST1 or ST2;
  - carrying out of method step ST3;
  - carrying out of a phase change ($S_{5A}$) between the transmission signal on the at least one transmitting antenna (6) and the transmission signal on the reference antenna (2) and/or carrying out of an amplitude change of the transmission signal on the at least one transmitting antenna (6) and/or of the transmission signal on the reference antenna (2) ;
  - repeating ($S_{4A}$) the previous method step ST3 and of the method step of phase change ($S_{5A}$) and/or amplitude change are carried out until at least one power value in each case is captured for at least two different phase values between the transmission signal on the at least one transmitting antenna (6) and the transmission signal on the reference antenna (2) and/or for at least two different amplitude values of the transmission signal on the at least one transmitting antenna (6) and/or of the transmission signal on the reference antenna (2);
  - Calculation ($S_{6A}$) of the phase difference on the active antenna (3) between the transmission signal which was transmitted by the at least one transmitting antenna (6) and the transmission signal which was transmitted by the reference antenna (2) with reference to the at least three power values, as well as determination of the magnitude of the transmission signal which was transmitted by the at least one transmitting antenna (6) and received by the active antenna (3), by:

    i) the measured result, that is to say the power value from the method step ST1 if this has been carried out and the at least one transmitting antenna (6) alone has transmitted the transmission signal; or
    ii) the at least three power values, if the method step ST2 has been carried out and the reference antenna (2) alone has transmitted the transmission signal;

or
b) :

- that the control unit (11) is designed to carry out the following method steps:

• carrying out of method step ST1;
• carrying out of method step ST2;
• carrying out of method step ST3;
• calculation ($S_{6B}$) of the phase difference on the active antenna (3) between the transmission signal which was transmitted by the at least one transmitting antenna (6) and the transmission signal which was transmitted by the reference antenna (2) with reference to the at least three power values, and determination of the magnitude of the transmission signal which was transmitted by the at least one transmitting antenna (6) and received by the active antenna (3) with the power value from the method step ST1 as only the at least one transmitting antenna (6) has transmitted the transmission signal,

or
c) :

- that the measuring device (1) has a phase controller (10) and/or an amplitude controller (9) which is connected between the signal generator (7) and the at least one transmitting antenna (6) and/or between the signal generator (7) and the reference antenna (2) and is controllable by the control unit;
- that the control unit (11) is designed to carry out the following method steps:

• carrying out of method step ST3;
• carrying out of a phase change ($S_{5C}$) between the transmission signal on the at least one transmitting antenna (6) and the transmission signal on the reference antenna (2) and/or carrying out of an amplitude change of the transmission signal on the at least one transmitting antenna (6) and/or of the transmission signal on the reference antenna (2) :
• repeating ($S_{4C}$) the previous method step ST3 of the method step of phase change ($S_{5C}$) and/or amplitude change are carried out until at least one power value in each case is captured for at least three different phase values between the transmission signal on the at least one transmitting antenna (6) and the transmission signal on the reference antenna (2) and/or for at least three different amplitude values of the transmission signal on the at least one transmitting antenna (6) and/or of the transmission signal on the reference antenna (2);
• calculation ($S_{6C}$) of the phase difference on the active antenna (3) between the transmission signal which was transmitted by the at least one transmitting antenna (6) and the transmission signal which was transmitted by the reference antenna (2), as well as calculation of the magnitude of the transmission signal which was transmitted by the at least one transmitting antenna (6) and received by the active antenna (3), with reference to the at least three power values.

16. The measuring device according to claim 15, **characterized in that** the phase controller (10) is designed and is controllable by the control unit (11) in such a way that the power values are captured for at least three or at least four different phase values between the transmission signal on the at least one transmitting antenna (6) and the transmission signal on the reference antenna (2) and/or for at least three or at least four different amplitude values of the transmission signal on the at least one transmitting antenna (6) and/or of the transmission signal on the reference antenna (2).

17. The measuring device according to claim 15 or 16, **characterized in that** the control unit (11) is designed in such a way as to control the phase controller (10) in such a way that it can set four successive phase changes of 0°, $\Delta$°, 2·$\Delta$° and 3·$\Delta$°, wherein $\Delta$° is in the range between 80° and 100° and preferably corresponds to 90°, between the transmission signal of the at least one transmitting antenna and the transmission signal on the reference antenna.

18. The measuring device according to one of claims 15 to 17, **characterized in that** the individual phase values which the phase controller (10) sets for a solid angle ($\vartheta$, $\varphi$) are spaced apart from one another by $\alpha$°, wherein

$$\alpha° = \frac{360°}{number\ of\ phase\ values} .$$

19. Measuring device according to one of claims 13 to 18, **characterized in that** the control unit (11) is designed in such a way that the active antenna (3) and reference antenna (2) can be jointly rotated and/or adjusted relative to the at least one transmitting antenna (6), so that different reception directions, that is to say solid angles ($\vartheta$, $\varphi$) can be measured.

20. The measuring arrangement according to claim 19, **characterized in that** the unit comprising the active antenna (3) and the reference antenna (2) is preferably rotatable and/or adjustable jointly with respect to its azimuth angle ($\varphi$) and/or its angle of elevation ($\vartheta$) relative to the at least one transmitting antenna (6).

21. Measuring device according to one of claims 13 to 20, **characterized in that** the measuring device (1) has an amplitude controller which is connected between the signal generator (7) and the at least one transmitting antenna (6) and/or between the signal generator (7) and the reference antenna (2) and that the control unit (11) is designed in such a way as to control the amplitude controller (9) in such a way that the amplitude of the transmission signal on the at least one transmitting antenna (6) and/or of the transmission signal on the reference antenna (2) can be set in such a way that the power level of a transmission signal at the location of the active antenna (3)is less than 20 times as high, preferably less than ten times as high, more preferably less than five times as high, or more preferably less than twice as high, as the power of the other transmission signal.

22. The measuring device according to one of claims 13 to 21, **characterized in that** the spacing between the reference antenna (2) and the active antenna (3) is less than 100 cm, preferably less than 50 cm, more preferably less than 25 cm and more preferably less than 10 cm.

23. The measuring device according to one of claims 13 to 22, **characterized in that** in addition an interface device (12) is connected the spacing between the control unit (11) and the active antenna (3).

24. The measuring device according to one of claims 13 to 23, **characterized in that** the at least one transmitting antenna (6) and/or the reference antenna (2) transmit a modulated or unmodulated transmission signal.

**Revendications**

1. Procédé de détermination de valeurs de puissance d'un signal reçu par une antenne active (3) afin de pouvoir déterminer avec celle-ci l'amplitude et la phase, avec les étapes de procédé suivantes :

   - l'emploi d'au moins une antenne d'émission (6) et une antenne de référence (2), l'antenne de référence (2) étant disposée par rapport à l'antenne active (3) avec une position prédéfinie et à une distance prédéfinie ;
   - l'emploi d'un générateur de signaux (7) pour la génération d'un signal d'émission, le générateur de signaux (7) étant relié avec l'au moins une antenne d'émission (6) et l'antenne de référence (2) ;

   dans lequel, à partir du groupe des étapes de procédé (ST1, ST2, ST3) suivantes :

   ST1 : d'un envoi unique ($S_1$) du signal d'émission par l'au moins une antenne d'émission (6) et de détection ($S_{1\_1}$) d'une valeur de puissance du signal d'émission reçu par l'antenne active (3) ;
   ST2 : d'un envoi unique ($S_2$) du signal d'émission par l'antenne de référence (2) et de détection ($S_{2\_1}$) d'une valeur de puissance du signal d'émission reçu par l'antenne active (3) ;
   ST3 : d'envoi simultané ($S_3$) du signal d'émission par le biais de l'au moins une antenne d'émission (6) et de l'antenne de référence (2), moyennant la génération de signaux d'émission superposés et de détection ($S_{3\_1}$) d'une valeur de puissance des signaux d'émission superposés reçus par l'antenne active (3) ;

   une suite d'au moins trois étapes de procédé (ST1, ST2, ST3), dans un ordre quelconque et avec une combinaison quelconque, est effectuée, également moyennant la réalisation multiple d'au moins une étape de procédé (ST1, ST2, ST3), la suite des au moins trois étapes de procédé (ST1, ST2, ST3) comprenant toujours au moins une fois l'étape de procédé ST3.

2. Procédé selon la revendication 1, **caractérisé en ce que**, pour la détection des au moins trois valeurs de puissance et ainsi pour la détermination de l'amplitude et de la phase d'au moins une des trois suites a), ou b), ou c), pour une orientation et une position identique de l'antenne active (3) et de l'antenne de référence (2) par rapport à l'au moins une antenne d'émission (6) :

   a) :

• l'exécution de l'étape de procédé ST1 ou de l'étape ST2 ;
• l'exécution de l'étape de procédé ST3 ;
• la répétition ($S_{4A}$) de l'étape de procédé ST3 jusqu'à ce qu'au total au moins trois valeurs de puissance soient détectées ;

ou
b) :

• l'exécution de l'étape de procédé ST1 ;
• l'exécution de l'étape de procédé ST2 ;
• l'exécution de l'étape de procédé ST3 ;

ou
c) :

• l'exécution de l'étape de procédé ST3 ;
• la répétition ($S_{4C}$) de l'étape de procédé ST3 jusqu'à ce qu'au total au moins trois valeurs de puissance soient détectées.

3. Procédé selon la revendication 2, **caractérisé en ce que** les suites a) ou b) ou c) sont plus précisément décrites par les étapes de procédé :

a) :

- utilisation d'un régulateur de phase (10) et/ou d'un régulateur d'amplitude (9), qui est connecté entre le générateur de signaux (7) et l'au moins une antenne d'émission (6) et/ou entre le générateur de signaux (7) et l'antenne de référence (2) ;
- exécution de l'étape de procédé ST1 ou ST2 ;
- exécution de l'étape de procédé ST3 ;
- exécution d'une modification de phase ($S_{5A}$) entre le signal d'émission au niveau de l'au moins une antenne d'émission (6) et le signal d'émission au niveau de l'antenne de référence (2), et/ou exécution d'une modification d'amplitude du signal d'émission au niveau de l'au moins une antenne d'émission (6) et/ou du signal d'émission au niveau de l'antenne de référence (2) ;
- répétition ($S_{4A}$) de l'étape de procédé ST3 et de l'étape de procédé de modification de phase ($S_{5A}$) et/ou de modification d'amplitude jusqu'à ce que pour au moins deux valeurs de phase différentes entre le signal d'émission au niveau de l'au moins une antenne d'émission (6) et le signal d'émission au niveau de l'antenne de référence (2) et/ou jusqu'à ce que pour au moins deux valeurs d'amplitude différentes du signal d'émission au niveau de l'au moins une antenne d'émission (6) et/ou du signal d'émission au niveau de l'antenne de référence (2), chaque fois, au moins une valeur de puissance soit détectée ;
- calcul ($S_{6A}$) de la différence de phases au niveau de l'antenne active (3) entre le signal d'émission qui a été émis à partir de l'au moins une antenne d'émission (6) et le signal d'émission qui a été émis à partir de l'antenne de référence (2) a été émis à l'aide des au moins trois valeurs de puissance, ainsi que détermination de l'amplitude du signal d'émission qui a été émis par l'au moins une antenne d'émission (6) et a été reçu par l'antenne active (3) par :

i) le résultat de mesure, c'est-à-dire la valeur de puissance, à partir de l'étape de procédé ST1, dans le cas où celle-ci a été exécutée, et l'au moins une antenne d'émission (6) a émis seule le signal d'émission ; ou
ii) les au moins trois valeurs de puissance, lorsque l'étape de procédé ST2 a été exécutée et l'antenne de référence (2) a émis seule le signal d'émission ;

ou
b) :

- exécution de l'étape de procédé ST1 ;
- exécution de l'étape de procédé ST2 ;
- exécution de l'étape de procédé ST3 ;
- calcul ($S_{6B}$) de la différence de phases au niveau de l'antenne active (3) entre le signal d'émission qui a été émis à partir de l'au moins une antenne d'émission (6) et le signal d'émission qui a été émis à partir de l'antenne de référence (2) à l'aide des au moins trois valeurs de puissance, et détermination de l'amplitude du signal d'émission qui a été émis par l'au moins une antenne d'émission (6) et a été reçu par l'antenne active (3) avec la valeur de puissance à partir de l'étape de procédé ST1 lorsque seule l'au moins une antenne d'émission (6) a émis le signal d'émission,

ou

c) :

- utilisation d'un régulateur de phase (10) et/ou d'un régulateur d'amplitude (9), qui est connecté entre le générateur de signaux (7) et l'au moins une antenne d'émission (6) et/ou entre le générateur de signaux (7) et l'antenne de référence (2), et/ou exécution d'une modification d'amplitude du signal d'émission au niveau de l'au moins une antenne d'émission (6) et/ou du signal d'émission au niveau de l'antenne de référence (2) ;
- exécution de l'étape de procédé ST3 ;
- exécution d'une modification de phase ($S_{5C}$) entre le signal d'émission au niveau de l'au moins une antenne d'émission (6) et le signal d'émission au niveau de l'antenne de référence (2), et/ou exécution d'une modification d'amplitude du signal d'émission au niveau de l'au moins une antenne d'émission (6) et/ou du signal d'émission au niveau de l'antenne de référence (2) ;
- répétition ($S_{4C}$) de l'étape de procédé ST3 et de l'étape de procédé de modification de phase ($S_{5C}$) et/ou de modification d'amplitude jusqu'à ce que, pour au moins trois valeurs de phase différentes entre le signal d'émission au niveau de l'au moins une antenne d'émission (6) et le signal d'émission au niveau de l'antenne de référence (2), et/ou jusqu'à ce que, pour au moins trois valeurs d'amplitude différentes du signal d'émission au niveau de l'au moins une antenne d'émission (6) et/ou du signal d'émission au niveau de l'antenne de référence (2), chaque fois au moins une valeur de puissance soit détectée ;
- calcul ($S_{6C}$) de la différence de phases au niveau de l'antenne active (3) entre le signal d'émission qui a été émis à partir de l'au moins une antenne d'émission (6) et le signal d'émission qui a été émis à partir de l'antenne de référence (2) à l'aide des au moins trois valeurs de puissance, ainsi que calcul de l'amplitude du signal d'émission qui a été émis par l'au moins une antenne d'émission (6) et a été reçu par l'antenne active (3) à l'aide des au moins trois valeurs de puissance.

4. Procédé selon la revendication 3, **caractérisé en ce que**, dans l'étape de procédé de répétition ($S_{4A}$, $S_{4C}$), l'étape de procédé ST3 et l'étape de procédé de modification de phase ($S_{5A}$, $S_{5C}$) et/ou de modification d'amplitude sont exécutées les unes après les autres de manière aussi fréquente jusqu'à ce que pour au moins trois des au moins quatre valeurs de phase différentes entre le signal d'émission au niveau de l'au moins une antenne d'émission (6) et le signal d'émission au niveau de l'antenne de référence (2), et/ou jusqu'à ce que pour au moins trois ou au moins quatre valeurs d'amplitude différentes du signal d'émission au niveau de l'au moins une antenne d'émission (6) et/ou du signal d'émission au niveau de l'antenne de référence (2), chaque fois au moins une valeur de puissance est détectée.

5. Procédé selon la revendication 3 ou la revendication 4, **caractérisé en ce que**, lors de l'exécution multiple de l'étape de procédé de modification de phase ($S_{5A}$, $S_{5C}$), quatre modifications de phase entre le signal d'émission de l'au moins une antenne d'émission (6) et le signal d'émission au niveau de l'antenne de référence (2) sont commutées les unes après les autres à $0°$, $\Delta°$, $2\Delta°$ et $3\Delta°$, où $\Delta°$ se situe dans la plage entre 80 ° et 100 °, correspond de préférence à 90 °.

6. Procédé selon l'une des revendications 3 à 5, **caractérisé en ce que** les valeurs de phases individuelles que règle le régulateur de phase (10) les unes après les autres pour un angle solide $(\vartheta, \varphi)$ sont espacées les unes des autres d'$\alpha°$, où

$$\alpha \; ° = \frac{360 \, °}{\text{nombre de valeurs de phases}}.$$

7. Procédé selon l'une des revendications précédentes, **caractérisé par** les nouvelles étapes de procédé suivantes :

- une rotation commune et/ou un changement de réglage ($S_7$) de l'antenne active (3) et de l'antenne de référence (2) constituant de préférence une entité par rapport à l'au moins une antenne d'émission (6) de sorte que des directions d'émission différentes peuvent être mesurées ;
- l'exécution ($S_8$) des étapes de procédé ST1 et/ou ST2, et/ou ST3, ou l'exécution des suites a) ou b) ou c).

8. Procédé selon la revendication 7, **caractérisé en ce que** pendant l'étape de procédé de rotation et/ou de changement de réglage ($S_7$), de préférence l'entité à base de l'antenne active (3) et de l'antenne de référence (2) est mise en rotation et/ou changée de réglage de manière commune par rapport à l'au moins une antenne d'émission (6) en ce qui concerne son angle azimutal ($\varphi$) et/ou son angle d'élévation ($\vartheta$).

9. Procédé selon la revendication 7 ou la revendication 8, **caractérisé par** les nouvelles étapes de procédé suivantes :

- une nouvelle exécution ($S_9$) des étapes de rotation ($S_7$) et d'exécution ($S_8$) jusqu'à ce que les amplitudes et les phases pour l'antenne active soient déterminées pour les angles solides ($\vartheta$, $\varphi$) souhaités ou pour tous les angles solides ($\vartheta$, $\varphi$).

10. Procédé selon l'une des revendications précédentes, **caractérisé par** les nouvelles étapes de procédé suivantes :

- l'utilisation d'un régulateur d'amplitude (9), qui est connecté entre le générateur de signaux (7) et l'au moins une antenne d'émission (6), et/ou entre le générateur de signaux (7) et l'antenne de référence (2) ;
- le réglage ($S_{10}$) de l'amplitude du signal d'émission au niveau de l'au moins une antenne d'émission (6) et/ou du signal d'émission au niveau de l'antenne de référence (2) de telle manière que l'ampleur de la puissance d'un signal d'émission soit inférieure à moins de 20 fois, de préférence à moins de dix fois, plus préférentiellement à moins de cinq fois, de manière encore préférée à moins de deux fois aussi élevée que la puissance de l'autre signal d'émission à l'emplacement de l'antenne active (3).

11. Procédé selon l'une des revendications précédentes, **caractérisé par** les nouvelles étapes de procédé suivantes :

- l'agencement de l'antenne de référence (2) sur l'antenne active (3) de telle manière que la distance entre l'antenne de référence (2) et l'antenne active (3) est inférieure à 100 cm, de préférence, inférieure à 50 cm, plus préférentiellement inférieure à 25 cm, de manière encore préférée inférieure à 10 cm.

12. Procédé selon l'une des revendications précédentes, **caractérisé en ce que** l'au moins une antenne d'émission (6) et/ou l'antenne de référence (2) émettent un signal d'émission modulé ou non modulé.

13. Dispositif de mesure (1) pour la détermination de valeurs de puissance d'un signal reçu par une antenne active (3) pour le calcul de l'amplitude et de la phase avec les caractéristiques suivantes :

- au moins une antenne d'émission (6) et une antenne de référence (2), l'antenne de référence (2) étant disposée par rapport à l'antenne active (3) avec une position prédéfinie et à une distance prédéfinie ;
- un générateur de signaux (7) pour la génération d'un signal d'émission, le générateur de signaux (7) étant relié avec l'au moins une antenne d'émission (6) et l'antenne de référence (2) ;
- une unité de commande (11) qui, pour une même orientation et position de l'antenne active (3) et de l'antenne de référence (2) est conçue en relation par rapport à l'au moins une antenne d'émission (6) de telle manière et est reliée avec l'antenne active (3) et le générateur de signaux (7) que les étapes de procédé suivantes sont exécutables :

ST1 : l'un envoi unique ($S_1$) du signal d'émission par l'au moins une antenne d'émission (6) et la détection ($S_{1\_1}$) d'une valeur de puissance du signal d'émission reçu par l'antenne active (3) ;
ST2 : l'un envoi unique ($S_2$) du signal d'émission par l'antenne de référence (2) et la détection ($S_{2\_1}$) d'une valeur de puissance du signal d'émission reçu par l'antenne active (3) ;
ST3 : l'envoi simultané ($S_3$) du signal d'émission par le biais de l'au moins une antenne d'émission (6) et de l'antenne de référence (2) moyennant la génération de signaux d'émission superposés et la détection ($S_{3\_1}$) d'une valeur de puissance des signaux d'émission superposés reçus par l'antenne active (3) ;

où l'unité de commande (11) est en outre conçue pour qu'une suite d'au moins trois étapes de procédé (ST1, ST2, ST3) dans un ordre quelconque et avec une combinaison quelconque, soit effectuée, également moyennant une réalisation multiple d'au moins une étape de procédé (ST1, ST2, ST3), la suite des au moins trois étapes de procédé (ST1, ST2, ST3) comprenant toujours au moins une fois l'étape de procédé ST3.

**14.** Dispositif de mesure selon la revendication 13, **caractérisé en ce que** l'unité de commande (11) est en outre conçue de telle manière :

- que, pour la détection des au moins trois valeurs de puissance et ainsi pour la détermination de l'amplitude et de la phase d'au moins d'au moins une des trois suites a), ou b), ou c) pour une orientation et une position identiques de l'antenne active (3) et de l'antenne de référence (2) par rapport à l'au moins une antenne d'émission (6), on effectue :

a) :

• l'exécution de l'étape de procédé ST1 ou de l'étape ST2 ;
• l'exécution de l'étape de procédé ST3 ;
• la répétition ($S_{4A}$) de l'étape de procédé ST3 jusqu'à ce qu'au total au moins trois valeurs de puissance soient détectées ;

ou
b) :

• l'exécution de l'étape de procédé ST1 ;
• l'exécution de l'étape de procédé ST2 ;
• l'exécution de l'étape de procédé ST3 ;

ou
c) :

• l'exécution de l'étape de procédé ST3 ;
• la répétition ($S_{4C}$) de l'étape de procédé ST3 jusqu'à ce qu'au total au moins trois valeurs de puissance soient détectées.

**15.** Dispositif de mesure selon la revendication 14, **caractérisé en ce que** les suites a), ou b), ou c) sont décrites plus précisément par les caractéristiques suivantes :

a) :

- que le dispositif de mesure (1) présente un régulateur de phase (10) et/ou d'un régulateur d'amplitude (9), qui est connecté entre le générateur de signaux (7) et l'au moins une antenne d'émission (6) et/ou entre le générateur de signaux (7) et l'antenne de référence (2) et qui peut être commandé par l'unité de commande ;
- que l'unité de commande (11) est conçue pour exécuter les étapes de procédé suivantes :

• l'exécution de l'étape de procédé ST1 ou ST2 ;
• l'exécution de l'étape de procédé ST3 ;
• l'exécution d'une modification de phase ($S_{5A}$) entre le signal d'émission au niveau de l'au moins une antenne d'émission (6) et le signal d'émission au niveau de l'antenne de référence (2), et/ou l'exécution d'une modification d'amplitude du signal d'émission au niveau de l'au moins une antenne d'émission (6) et/ou du signal d'émission au niveau de l'antenne de référence (2) ;
• la répétition ($S_{4A}$) de l'étape de procédé ST3 et de l'étape de procédé de modification de phase ($S_{5A}$) et/ou de modification d'amplitude jusqu'à ce que, pour au moins deux valeurs de phase différentes entre le signal d'émission au niveau de l'au moins une antenne d'émission (6) et le signal d'émission au niveau de l'antenne de référence (2), et/ou jusqu'à ce que pour au moins deux valeurs d'amplitude différentes du signal d'émission au niveau de l'au moins une antenne d'émission (6) et/ou du signal d'émission au niveau de l'antenne de référence (2), chaque fois au moins une valeur de puissance soit détectée ;
• le calcul ($S_{6A}$) de la différence de phases au niveau de l'antenne active (3) entre le signal d'émission qui a été émis à partir de l'au moins une antenne d'émission (6) et le signal d'émission qui a été émis à partir de l'antenne de référence (2), a été émis à l'aide des au moins trois valeurs de puissance, ainsi que détermination de la contribution du signal d'émission qui a été émis par l'au moins une antenne d'émission (6) et a été reçu par l'antenne active (3) :

i) par le résultat de mesure, c'est-à-dire la valeur de puissance à partir de l'étape de procédé ST1 dans le cas où celle-ci a été exécutée et l'au moins une antenne d'émission (6) a émis seule le signal d'émission ; ou

ii) par les au moins trois valeurs de puissance, lorsque l'étape de procédé ST2 a été exécutée et l'antenne de référence (2) a émis seule le signal d'émission ;

ou

b) :

- que l'unité de commande (11) est conçue pour exécuter les étapes de procédé suivantes :

• l'exécution de l'étape de procédé ST1 ;
• l'exécution de l'étape de procédé ST2 ;
• l'exécution de l'étape de procédé ST3 ;
• le calcul ($S_{6B}$) de la différence de phases au niveau de l'antenne active (3) entre le signal d'émission qui a été émis à partir de l'au moins une antenne d'émission (6) et le signal d'émission qui a été émis à partir de l'antenne de référence (2) à l'aide des au moins trois valeurs de puissance, et la détermination de l'amplitude du signal d'émission qui a été émis par l'au moins une antenne d'émission (6) et a été reçu par l'antenne active (3) avec la valeur de puissance à partir de l'étape de procédé ST1 en tant que seule l'au moins une antenne d'émission (6) a émis le signal d'émission ;

ou

c) :

- que le dispositif de mesure (1) présente un régulateur de phase (10) et/ou un régulateur d'amplitude (9), qui est connecté entre le générateur de signaux (7) et l'au moins une antenne d'émission (6) et/ou entre le générateur de signaux (7) et l'antenne de référence (2) et qui peut être commandé par l'unité de commande ;
- que l'unité de commande (11) est conçue pour exécuter les étapes de procédé suivantes :

• l'exécution de l'étape de procédé ST3 ;
• l'exécution d'une modification de phase ($S_{5C}$) entre le signal d'émission au niveau de l'au moins une antenne d'émission (6) et le signal d'émission au niveau de l'antenne de référence (2), et/ou l'exécution d'une modification d'amplitude du signal d'émission au niveau de l'au moins une antenne d'émission (6) et/ou du signal d'émission au niveau de l'antenne de référence (2) ;
• la répétition ($S_{4C}$) de l'étape de procédé ST3 et de l'étape de procédé de modification de phase ($S_{5C}$) et/ou de modification d'amplitude jusqu'à ce que pour au moins trois valeurs de phase différentes entre le signal d'émission au niveau de l'au moins une antenne d'émission (6) et le signal d'émission au niveau de l'antenne de référence (2), et/ou jusqu'à ce que pour au moins trois valeurs d'amplitude différentes du signal d'émission au niveau de l'au moins une antenne d'émission (6) et/ou du signal d'émission au niveau de l'antenne de référence (2), chaque fois au moins une valeur de puissance soit détectée ;
• le calcul ($S_{6C}$) de la différence de phases au niveau de l'antenne active (3) entre le signal d'émission qui a été émis à partir de l'au moins une antenne d'émission (6) et le signal d'émission qui a été émis à partir de l'antenne de référence (2), ainsi que le calcul de l'amplitude du signal d'émission qui a été émis par l'au moins une antenne d'émission (6) et a été reçu par l'antenne active (3) à l'aide des au moins trois valeurs de puissance.

16. Dispositif de mesure selon la revendication 15, **caractérisé en ce que** le régulateur de phase (10) est conçu de telle manière et peut être commandé par l'unité de commande (11) que les valeurs de puissance pour au moins trois ou au moins quatre valeurs de phase différentes entre le signal d'émission au niveau de l'au moins une antenne d'émission (6) et le signal d'émission au niveau de l'antenne de référence (2), et/ou jusqu'à ce qu'au moins trois ou au moins quatre valeurs d'amplitude différentes du signal d'émission au niveau de l'au moins une antenne d'émission (6) et/ou du signal d'émission au niveau de l'antenne de référence (2) puisse être détecté.

17. Dispositif de mesure selon la revendication 15 ou la revendication 16, **caractérisé en ce que** l'unité de commande (11) est conçue de manière à commande le régulateur de phase (10) de telle manière que par celui-ci quatre modifications de phases peuvent être réglées l'une après l'autre entre le signal d'émission de l'au moins une antenne d'émission (6) et le signal d'émission au niveau de l'antenne de référence (2) de 0°, Δ°, 2Δ° et 3Δ°, où Δ° se situe dans la plage entre 80° et 100°, correspond de préférence à 90°.

**18.** Dispositif de mesure selon l'une des revendications 15 à 17, **caractérisé en ce que** les valeurs de phases individuelles que règle le régulateur de phase (10) les unes après les autres pour un angle solide ($\vartheta$, $\varphi$) sont espacées les unes des autres d'$\alpha$°, où

$$\alpha \, ° = \frac{360\,°}{\text{nombre de valeurs de phases}}.$$

**19.** Dispositif de mesure selon l'une des revendications 13 à 18, **caractérisé en ce que** l'unité de commande (11) est conçue de telle manière qu'elle puisse tourner et/ou être réglée conjointement l'antenne active (3) constituée de préférence d'une unité et l'antenne de référence (2) par rapport à l'au moins une antenne d'émission (6), de sorte que des directions de réception différentes, c'est-à-dire des angles solides ($\vartheta$, $\varphi$), puissent être mesurés.

**20.** Dispositif de mesure selon la revendication 19, **caractérisé en ce que**, de préférence, l'unité à base de l'antenne active (3) et de l'antenne de référence (2) puisse être tournée et/ou puisse être réglée en ce qui concerne son angle azimutal ($\varphi$) et/ou son angle d'élévation ($\vartheta$), conjointement, par rapport à l'au moins une antenne d'émission (6).

**21.** Dispositif de mesure selon l'une des revendications 13 à 20, **caractérisé en ce que** le dispositif de mesure (1) présente un régulateur d'amplitude (9) qui est connecté entre le générateur de signaux (7) et l'au moins une antenne d'émission (6), et/ou entre le générateur de signaux (7) et l'antenne de référence (2), et que l'unité de commande (11) est conçue de manière à commander le régulateur d'amplitude (9) de sorte que l'amplitude du signal d'émission au niveau de l'au moins une antenne d'émission (6), et/ou du signal d'émission au niveau de l'antenne de référence (2), puisse être réglée de telle manière que l'ampleur de la puissance d'un signal d'émission à l'emplacement de l'antenne active (3) est inférieure à moins de 20 fois, de préférence à moins de dix fois, plus préférentiellement à moins de cinq fois, de manière encore préférée à moins de deux fois aussi élevée que la puissance de l'autre signal d'émission.

**22.** Dispositif de mesure selon l'une des revendications 13 à 21, **caractérisé en ce que** la distance entre l'antenne de référence (2) et l'antenne active (3) est inférieure à 100 cm, de préférence, inférieure à 50 cm, plus préférentiellement inférieure à 25 cm, de manière encore préférée inférieure à 10 cm.

**23.** Dispositif de mesure selon l'une des revendications 13 à 22, **caractérisé en ce qu'**en outre un appareil d'interface (12) est connecté entre l'unité de commande (11) et l'antenne active (3).

**24.** Dispositif de mesure selon l'une des revendications 13 à 23, **caractérisé en ce que** l'au moins une antenne d'émission (6) et/ou l'antenne de référence (2) émettent un signal d'émission modulé ou non modulé.

Fig. 1

EP 3 051 303 B1

Fig. 2A

Fig. 2B

Fig. 3

Empfangsleistung

Phasenst. = 270° bei $\vartheta_3$, $\varphi_3$

Phasenst. = 270° bei $\vartheta_1$, $\varphi_1$

Phasenst. = 270° bei $\vartheta_2$, $\varphi_2$

Phasenst. = 180° bei $\vartheta_3$, $\varphi_3$

Phasenst. = 90° bei $\vartheta_3$, $\varphi_3$

Phasenst. = 0° bei $\vartheta_3$, $\varphi_3$

$\gamma(\vartheta_1, \varphi_1) = 30°$

$\gamma(\vartheta_2, \varphi_2) = 100°$

$\gamma(\vartheta_3, \varphi_3) = 240°$

Einstellung Phasensteller

0° 45° 90° 135° 180° 225° 270° 315° 360°

2 1.8 1.6 1.4 1.2 1 0.8 0.6 0.4 0.2 0

Fig. 4

Start ST1

Aussenden des Sendesignals allein durch die zumindest eine Sendeantenne; $S_1$

Erfassen des Betrags des empfangenen Sendesignals; $S_{1\_1}$

Ende

Start ST2

Aussenden des Sendesignals allein durch die Referenzantenne; $S_2$

Erfassen des Betrags des empfangenen Sendesignals; $S_{2\_1}$

Ende

Start ST3

Aussenden des Sendesignals durch die zumindest eine Sendeantenne und die Referenzantenne (überlagerte Sendesignale); $S_3$

Leistungserfassung der überlagerten Sendesignale; $S_{3\_1}$

Ende

Fig. 5

Start a)

↓

Durchführen von ST1 oder ST2;

↓

Durchführen von ST3;

↓

Wiederholen von ST3 bis insgesamt zumindest drei Leistungswerte erfasst sind; $S_{4A}$

↓

Ende

## Fig. 6A

Start b)

↓

Durchführen von ST1 und ST2 und ST3 in beliebiger Reihenfolge;

↓

Ende

## Fig. 6B

Start c)

↓

Durchführen von ST3;

↓

Wiederholen von ST3 bis insgesamt zumindest drei Leistungswerte erfasst sind; $S_{4C}$

↓

Ende

## Fig. 6C

Start a)

Durchführen von ST1 oder ST2

Durchführen von ST3

$S_{5A}$

Ändern der Phase zwischen den Sendesignalen der Sendeantenne und der Referenzantenne und/oder Ändern der Amplitude des Sendesignals an der Sendeantenne und/oder Referenzantenne;

$S_{4A}$

Wiederholen des Schrittes ST3 und Phasenveränderung $S_{5A}$ und/oder Amplitudenveränderung bis zumindest zwei verschiedene Phasenwerte und/oder Amplitudenwerte nacheinander eingestellt und zu jedem Phasenwert und/oder Amplitudenwert zumindest ein Leistungswert gemessen ist;

$S_{6A}$

Berechnung der Phasendifferenz zwischen dem Sendesignal der Sendeantenne und dem Sendesignal der Referenzantenne und Bestimmung des Betrags des Sendesignals, das von der Sendeantenne ausgesendet und von der aktiven Antenne empfangen worden ist.

Ende

Fig. 7A

Start b)

Durchführen von ST1 und ST2 und ST3 in beliebiger
Reihenfolge;

$S_{6B}$

Berechnung der Phasendifferenz zwischen dem Sendesignal
der Sendeantenne und dem Sendesignal der
Referenzantenne, wobei die beiden Sendesignale von der
aktiven Antenne empfangen werden anhand der zumindest
drei Leistungswerte und Bestimmen des Betrags des
Sendesignals, das von der Sendeantenne ausgesendet und
von der aktiven Antenne empfangen wurde;

Ende

Fig. 7B

Start c)

Durchführen von ST3;

$S_{5C}$

Ändern der Phase zwischen den Sendesignalen der Sendeantenne und der Referenzantenne und/oder Ändern der Amplitude des Sendesignals an der Sendeantenne und/oder Referenzantenne;

$S_{4C}$

Wiederholen des Schrittes ST3 und Phasenänderung ($S_{5C}$) und/oder Amplitudenveränderung bis insgesamt zumindest drei Leistungswerte gemessen sind, wobei bei jedem Leistungswert eine unterschiedliche Phase und/oder Amplitude eingestellt war;

$S_{6C}$

Berechnung der Phasendifferenz zwischen dem Sendesignal der Sendeantenne und dem Sendesignal der Referenzantenne, wobei die beiden Sendesignale von der aktiven Antenne empfangen werden, sowie Berechnung des Betrags des Sendesignals das von der Sendeantenne ausgesendet und von der aktiven Antenne empfangen wird anhand der zumindest drei Leistungswerte.

Ende

Fig. 7C

Start

$S_7$

Gemeinsames Verdrehen und/oder Verstellen der zueinander fixierten aktiven Antenne und Referenzantenne relativ gegenüber der Sendeantenne;

$S_8$

Durchführen der Schritte ST1 und/oder ST2 und/oder ST3 oder Durchführen der Abfolgen a) oder b) oder c).

Ende

Fig. 8

Start

$S_9$

Erneutes Ausführen der Schritte Verdrehen und Durchführen, bis das Antennenfernfelddiagramm für die aktive Antenne für die gewünschten Raumwinkel oder für alle Raumwinkel erstellt werden kann.

Ende

Fig. 9

Start

$S_{10}$

Einstellen der Amplitude des Sendesignals an der Sendeantenne und/oder an der Referenzantenne, sodass beide Amplituden an der Messantenne in etwa gleich hoch sind.

Ende

Fig. 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2811307 A1
- US 20030117315 A1